# EUROPÄISCHE PATENTANMELDUNG

(11) **EP 4 588 654 A1**
(43) Veröffentlichungstag der Anmeldung: **23.07.2025**
(21) Anmeldenummer: 24152025.3
(22) Anmeldetag: 16.01.2024
(51) Int. Cl.: B32B 7/04, C23C 14/00, C23C 16/40, C23C 28/00, B32B 15/08, B32B 15/18, B32B 15/20, B32B 25/04, B32B 25/14, B32B 25/16, B32B 25/18, B32B 27/08, B32B 27/28, B32B 27/34, B32B 27/36, B32B 27/38, B32B 27/40

(54) **VERBUNDMATERIAL MIT HAFTVERMITTLERSCHICHT**

(71) Anmelder: Carl Freudenberg KG, 69469 Weinheim (DE)
(72) Erfinder: von Fragstein, Friederike, 69120 Heidelberg (DE); SCHMIDT, Stanislaus, 68163 Mannheim (DE); STEINDL, Markus, 6361 Hopfgarten im Brixental (AT); MARKSTEINER, Albin, 6336 Langkampfen (AT); DIEHL, Marcel, 69493 Hirschberg (DE); RUTZ, Stephan, 69469 Weinheim (DE); FELLER, Kai, 67295 Bolanden (DE); HALLSTEIN, Katharina, 64658 Fuerth/Kroeckelbach (DE); RAPP, Christin, 68161 Mannheim (DE)

(57) **Zusammenfassung**

Die Erfindung betrifft ein Verbundmaterial, das eine Substratschicht und eine Polymerschicht aufweist, wobei Polymerschicht und Substratschicht unmittelbar durch eine Haftvermittlerschicht miteinander verbunden sind, und wobei die Haftvermittlerschicht durch plasmagestützte chemische Gasphasenabscheidung (PE-CVD) erhältlich ist, bei der zumindest teilweise ein Vorläufermaterial eingesetzt wird, das mindestens eine siliciumorganische Verbindung enthält, wobei die Polymerschicht eine Shore-Härte, gemessen nach DIN ISO 7619-1: 2021-02, Shore A, 23 °C, von 60 bis 95 Shore A aufweist. Die Erfindung betrifft auch Verfahren zur Herstellung solcher Verbundmaterialien, Dichtungsartikel und Verwendungen.

## Beschreibung

Die Erfindung betrifft ein Verbundmaterial, das eine Substratschicht und eine Polymerschicht aufweist, die durch eine Haftvermittlerschicht miteinander verbunden sind. Die Erfindung betrifft auch Verfahren zur Herstellung der Verbundmaterialien, Dichtungsartikel und Verwendungen.

### Stand der Technik

Verbundmaterialien sind Werkstoffe aus unterschiedlichen miteinander verbundenen Materialien, deren Werkstoffeigenschaften kombiniert werden. Sie bestehen oft aus Schichten unterschiedlicher, miteinander verbundener Materialien. Verbundmaterialien werden unter anderem eingesetzt, um ein Substrat an der Oberfläche mit anderen Eigenschaften auszustatten. So sind Verbundmaterialien aus Metallen und Polymeren bekannt, die durch die Metallkomponente eine hohe Härte und an einer Polymeroberfläche eine hohe Elastizität aufweisen. In anderen Verbundmaterialien werden verschiedene Kunststoffe mit unterschiedlichen Eigenschaften in vorteilhafter Weise kombiniert.

Bei Verbundmaterialien besteht das grundsätzliche Problem, dass die verschiedenen Materialien dauerhaft und stabil miteinander verbunden werden müssen. Dies ist insbesondere problematisch, wenn die Komponenten sehr unterschiedliche physikalische und chemische Eigenschaften aufweisen. Dies kann bei Metallen und Elastomeren, aber auch bei verschiedenen Kunststoffen der Fall sein. Die Schichten eines solchen Verbundmaterials werden im Stand der Technik oft stoffschlüssig durch Kleben oder Schweißen verbunden. Die Oberflächen der Schichten können für eine bessere Anbindung auch aktiviert werden, beispielsweise durch Funktionalisierung im Plasma oder durch chemische Reaktion mit einem Primer. Um wenig kompatible Materialien zu verbinden, können auch Haftvermittlerschichten eingesetzt werden. Solche Haftvermittlerschichten werden oft durch Auftragen von nasschemischen Bindemitteln erzeugt, beispielsweise aus Lösungen oder Schmelzen.

Verbundmaterialien aus Komponenten mit sehr unterschiedlichen Eigenschaften sind insbesondere im Gebiet der Dichtungstechnik von Bedeutung. Dabei werden beispielsweise sehr harte, stabile Komponenten mit elastischen Materialien kombiniert, die unter anderem formschlüssige, dichtende Verbindung ermöglichen. Verbundmaterialien aus harten Grundstoffen und Elastomeren werden in der Dichtungstechnik auch eingesetzt, um die Grundstoffe mit einer entsprechend den Anwendungsbedingungen besseren Dichtwirkung gegenüber verschiedenen Medien auszustatten.

Im Stand der Technik sind Verbundmaterialien bekannt, bei denen auf einem Substrat durch plasmagestützte chemische Gasphasenabscheidung (PE-CVD) eine Haftvermittlerschicht aufgetragen wird, die mit einer weiteren Schicht verbunden wird. So beschreibt die WO 01/61069 A2 Verfahren zur Herstellung von Verbundmaterialien aus Kunststoff und Metall, bei denen auf ein Metallsubstrat durch PE-CVD eine kohlenstoffreiche Schicht aufgetragen wird. Als Vorläuferverbindung im Plasma wird dabei Acetylen eingesetzt. Es ist bekannt, dass durch Abscheidung von Acetylen im Plasma hochvernetzte amorphe Kohlenstoffschichten erhalten werden, die auch als "Diamond-like Carbon" (DLC) bezeichnet werden. Dabei wird auch vorgeschlagen, solche mit Kohlenstoff im Plasma beschichtete Metallsubstrate mit Kunststoffen zu verbinden. Haftvermittlerschichten aus DLC, die im Wesentlichen aus Kohlenstoff, Wasserstoff und gegebenenfalls noch geringen Anteilen an Sauerstoff bestehen, weisen jedoch verschiedene Nachteile auf. So ist die Anbindung an viele Substrate, insbesondere metallische Substrate, und dabei vor allem an Edelstahl, oft unzureichend. Auch ist nachteilig, dass DLC-Schichten eine relativ hohe Eigenspannung aufweisen, was die Schichtstabilität und Haftung auf dem Substrat reduzieren kann. Dies kann dazu führen, dass solche DLC-Schichten von dem Substrat abplatzen. Die Stabilität solcher Verbundmaterialien mit DLC-Schichten ist daher noch verbesserungsbedürftig.

Weitere Verbundmaterialien mit im Plasma erzeugten Haftvermittlerschichten werden in der WO 01/38596 A2 beschrieben. Dabei wird vorgeschlagen, metallische Substrate mit einer Haftvermittlerschicht auszustatten, die aus einem oxidierenden Gas und Organosiliciumverbindungen wie Hexamethyldisiloxan (HMDSO), die nicht Tetramethylsilan sind, als Vorläuferverbindungen zu erzeugen. Das mit der Haftvermittlerschicht ausgestattete Substrat wird anschließend mit einem organischen Überzug ausgestattet, der bevorzugt ein Lack ist. Insbesondere wird ein Coil-Coating-Lack eingesetzt und eingebrannt. Lacke haben aber in der Regel nur eine geringe Schichtdicke von wenigen Mikrometern und im Vergleich zu Elastomeren höhere Härte und sind somit als Dichtwerkstoffe schlecht geeignet.

Die DE 198 56 227 A1 offenbart Verbundmaterialien aus Fluorpolymeren und weiteren Materialien, wie Metallen, Klebstoffen oder Elastomeren. Dabei wird die Oberfläche eines Fluorpolymers im Plasma mit einer Haftvermittlerschicht ausgestattet. Es werden verschiedene Vorläuferverbindungen für die Reaktion im Plasma vorgeschlagen, wobei die Reaktion konkret nur mit HMDSO durchgeführt wird, so dass die Haftvermittlerschicht eine relativ hohe Härte aufweist. Auch bei diesen Materialien ist die stabile und dauerhafte Anbindung an weitere Materialien, wie Elastomere, noch verbesserungsbedürftig.

EP3132861A3 beschreibt ein Verfahren zur Beschichtung eines Substrats unter Verwendung eines Plasmas, wobei wenigstens eine Oberfläche des Substrats in einem ersten Schritt mittels des Plasmas aktiviert und in einem zweiten Schritt im Plasma ein Silan auf die Oberfläche des Substrats aufpolymerisiert wird, und wobei anschließend auf die Oberfläche des Substrats ein Elastomer aufgebracht wird. Das Silan kann im Vakuum oder bei Atmosphärendruck abgeschieden werden und verschieden funktionelle Gruppen zur Haftvermittlung aufweisen. Auch bei diesen Materialien ist die stabile und dauerhafte Anbindung an weitere Materialien, wie Elastomere, noch verbesserungsbedürftig.

EP 3 680 100 A1 beschreibt ein Verbundmaterial, das ein Substrat und eine Polymerschicht aufweist, die durch eine Haftvermittlerschicht miteinander verbunden sind, wobei die Haftvermittlerschicht durch plasmagestützte chemische Gasphasenabscheidung (PE-CVD) erhältlich ist, bei der zumindest teilweise ein Gemisch von Vorläuferverbindungen eingesetzt wird, das einen ungesättigten Kohlenwasserstoff und eine siliciumorganische Verbindung enthält. Das Verbundmaterial ermöglicht bereits eine stabile und dauerhafte Bindung zu einer Vielzahl von Substraten. Im Stand der Technik besteht jedoch bei steigenden Anforderungen ein kontinuierlicher Bedarf an verbesserten Verbundmaterialien, bei denen Schichten aus unterschiedlichen Materialien stabil miteinander verbunden sind.

### Aufgabe der Erfindung

Der Erfindung liegt die Aufgabe zugrunde, Verbundmaterialien, Verfahren und Verwendungen bereitzustellen, welche die oben beschriebenen Probleme lösen. Insbesondere liegt der Erfindung die Aufgabe zugrunde, Verfahren und Verbundmaterialien bereitzustellen, die eine stabile Verbindung unterschiedlicher Materialien ermöglichen.

Dabei liegt der Erfindung insbesondere das Problem zugrunde, Metalle mit Polymeren oder verschiedene Polymere miteinander stabil zu verbinden. Insbesondere besteht das Problem, starre Materialien, wie Metalle oder starre Kunststoffe, mit flexiblen, elastischen Materialien, wie Elastomeren, stabil zu verbinden. Dabei soll die Verbindung auch dann stabil sein, wenn die Materialien lediglich in Teilbereichen miteinander verbunden sind.

Die Verbundmaterialien sollen dabei bevorzugt aus üblichen Komponenten und mit relativ einfachen Verfahren in wenigen Schritten erhältlich sein.

Der Erfindung liegt weiterhin die Aufgabe zugrunde, Haftvermittlerschichten bereitzustellen, die auf einer Vielzahl von verschiedenen, insbesondere starren, Substraten gut haften und dabei insbesondere eine stabile Verbindung mit elastischen Materialien ermöglichen.

### Offenbarung der Erfindung

Überraschenderweise wird die der Erfindung zugrunde liegende Aufgabe gelöst durch Verbundmaterialien und Verfahren gemäß den Patentansprüchen.

Gegenstand der Erfindung ist ein Verbundmaterial, das eine Substratschicht und eine Polymerschicht aufweist, wobei Polymerschicht und Substratschicht unmittelbar durch eine Haftvermittlerschicht miteinander verbunden sind, wobei die Haftvermittlerschicht durch plasmagestützte chemische Gasphasenabscheidung (PE-CVD) erhältlich ist, bei der zumindest teilweise ein Vorläufermaterial eingesetzt wird, das mindestens eine siliciumorganische Verbindung enthält, und wobei die Polymerschicht eine Shore- Härte, gemessen nach DIN ISO 48-4: 2021-02, von 60 bis 95 Shore A aufweist.

Das Verbundmaterial weist mindestens drei Schichten auf. Die Schichten sind flächig und stabil miteinander verbunden. Polymerschicht und Substratschicht sind ferner unmittelbar durch eine Haftvermittlerschicht miteinander verbunden. Es sind somit keine weiteren Schichten zwischen der Haftvermittlerschicht und der Substratschicht sowie zwischen der Haftvermittlerschicht und der Polymerschicht vorhanden. Das Verbundmaterial kann jedoch auf der jeweils von der Haftvermittlerschicht abgewandten Seite der Substratschicht oder Polymerschicht weitere Schichten aufweisen. Die drei Schichten des Verbundmaterials, d.h. die Substratschicht, die Haftvermittlerschicht und die Polymerschicht, sind stoffschlüssig miteinander verbunden. Dabei ist die Haftvermittlerschicht bevorzugt kovalent mit der Polymerschicht verbunden, wobei die Bindung insbesondere durch eine Vernetzungsreaktion erfolgte. Bevorzugt ist auch die Substratschicht kovalent mit der Haftvermittlerschicht verbunden.

Die Polymerschicht ist unmittelbar durch die Haftvermittlerschicht mit der Substratschicht verbunden. Dies bedeutet, dass zwischen der Substratschicht und der Polymerschicht nur die Haftvermittlerschicht vorhanden ist, die im Plasma erzeugt wurde. Erfindungsgemäß sind die Substratschicht, die Haftvermittlerschicht und die Polymerschicht nicht über ein zusätzliches Bindemittel verbunden. Es ist nicht erforderlich, die Polymerschicht mit der plasmabeschichteten Substratschicht unter Einsatz eines zusätzlichen Bindemittels zu verbinden. Es wurde gefunden, dass ein hochstabiles Verbundmaterial erhalten werden kann, wenn die Polymerschicht unmittelbar auf die Haftvermittlerschicht aufgetragen wird. Erfindungsgemäß weist das Verbundmaterial daher zwischen der Substratschicht, der Polymerschicht und der Haftvermittlerschicht kein zusätzliches Bindemittel auf.

Überraschenderweise wurde gefunden, dass bei der Verwendung einer Polymerschicht mit einer Shore A Härte von 60 bis 95 Shore A, gemessen nach DIN ISO 7619-1: 2021-02, in Verbindung mit einer Haftvermittlerschicht, die durch plasmagestützte chemische Gasphasenabscheidung (PE-CVD) erhältlich ist und bei der zumindest teilweise ein Vorläufermaterial eingesetzt wird, das eine siliciumorganische Verbindung enthält, eine besonders stabile Verbindung zu den verschiedensten Substratschichten erhalten werden kann.

Ohne sich auf einen Mechanismus festzulegen, wird vermutet, dass die siliciumorganische Verbindung eine besonders günstige Wirkung auf die Grenzflächeneigenschaften hat, da im Vergleich zu reinen Kohlenwasserstoffschichten bei siliciumorganischen Vorläuferverbindungen besonders viele funktionelle Gruppen für die Verbindung von Substrat- und Polymerschichten zur Verfügung stehen. Die günstige Wirkung der siliciumorganischen Verbindung wird durch die Kombination mit der Polymerschicht mit einer höheren Shore A-Härte besonders effizient erzielt, weil die Grenzflächenkräfte aufgrund der hohen Härte der Polymerschicht besonders vorteilhaft im Verbund verteilt werden. Ebenfalls vorteilhaft wirken sich dabei auch die intrinsischen Eigenschaften der Haftvermittlerschicht aus, da diese dreidimensional hochvernetzt und ebenfalls vergleichsweise hart ist, was die Verteilung der auf die Grenzflächen wirkenden Kräfte noch weiter verbessert.

Die Schichten sind so stabil miteinander verbunden, dass auf eine zusätzliche formschlüssige Verbindung verzichtet werden kann. In einer Ausführungsform weist die Substratschicht mithin Bereiche auf, in denen sie nicht mit der Polymerschicht verbunden ist. Durch diese lediglich teilweise Überdeckung der Substratschicht mit der Polymerschicht kommt der stoffschlüssigen Verbindung zwischen den Schichten besondere Bedeutung zu. Dies steht im Gegensatz zu vollständig mit Polymer umschlossenen Substratschichten, da hier eine formschlüssige Verbindung zur stoffschlüssigen Verbindung hinzukommt, was die Haftung erleichtert. Vorteilhaft an der erfindungsgemäßen Ausgestaltung ist, dass für die Produktgestaltung mehr technische Freiheitsgrade zur Verfügung gestellt werden können. In einer Ausführungsform ist die Verbindung zwischen Polymerschicht und Substratschicht keine formschlüssige Verbindung.

In einer speziellen Ausführungsform weist die Substratschicht mithin Bereiche auf, die unmittelbar durch die Haftvermittlerschicht mit der Polymerschicht verbunden sind, und andere Bereiche, die nicht mit der Polymerschicht verbunden sind.

Wesentliches Merkmal der überraschend guten Verbindung zwischen Substrat-, Haftvermittler- und Polymerschicht ist eine Kombination von siliciumorganischen Vorläuferverbindungen im Plasma und Polymerschichten mit einer Shore-Härte zwischen 60 und 95 Shore A. Es wird vermutet, dass hierdurch eine besonders gute Anpassung der Grenzflächeneigenschaften der Verbundpartner erzielt werden kann. Insbesondere scheint die Kombination der Haftvermittlerschicht, die spröde und dreidimensional hoch vernetzt ist, und einer Polymerschicht mit spezifischer Härte es zu ermöglichen, dass die Grenzflächenkräfte besonders vorteilhaft im Verbund verteilt werden können. Bevorzugt weist die Polymerschicht eine Shore-Härte von 60 bis 85 Shore A und insbesondere von 60 bis 80 Shore A, gemessen nach DIN ISO 7619-1: 2021-02, auf.

Dabei kann die Substratschicht grundsätzlich aus jedem Material, das im Plasma mit einer Beschichtung auf Basis von Si, C, sowie optional O und H ausgestattet werden kann, bestehen. Beispielsweise kann die Substratschicht eine Metallschicht, eine Kunststoffschicht oder eine Keramikschicht sein. In einer Ausführungsform ist die Substratschicht starr. Die Substratschicht kann auch selbst ein Verbundmaterial sein, und dabei beispielsweise eine Polymerschicht sein, die Füllstoffe, Fasern oder andere Komponenten enthält. Bevorzugt ist die Substratschicht eine Metallschicht oder eine Kunststoffschicht.

In einer besonders bevorzugten Ausführungsform ist die Substratschicht eine Metallschicht. Im Plasma können Metallschichten besonders effizient mit Beschichtungen auf Basis von Si, C, sowie optional O und H ausgestattet werden. Vorzugsweise weist die Metallschicht mindestens ein Metall ausgewählt aus der Gruppe bestehend aus Eisen, Eisenlegierungen, Aluminium, Aluminiumlegierungen, Kupfer, Kupferlegierungen, Nickel, Nickellegierungen, Titan und/ oder Titanlegierung auf. Bevorzugte Eisenlegierungen sind Stahl, insbesondere Edelstahl. Bevorzugte Aluminiumlegierungen enthalten als Legierungselemente Magnesium, Kupfer, Mangan, Zink und/oder Silicium. Eine bevorzugte Kupferlegierung ist Messing. Bevorzugte Nickellegierungen enthalten als Legierungselemente Kohlenstoff, Chrom, Molybdän, Aluminium, Kupfer, Niob, Titan und/oder Eisen. Bevorzugte Titanlegierungen enthalten als Legierungselemente Aluminium, Nickel, Tantal, Vanadium, Zinn, Molybdän, Zirconium und Eisen und/oder Edelmetallen wie Platin, Palladium, Rhodium und/oder Ruthenium. Eine Legierung kann durch die Zugabe von Legierungselementen zu einem Basismetall erhalten werden. Das Basismetall stellt die gewichtsanteilsmäßige Hauptkomponente in der Legierung dar.

Besonders bevorzugt besteht die Metallschicht aus einem oder mehreren der zuvor genannten Metalle. Wie dem Fachmann bekannt ist, können die Metalle oberflächlich oxidiert oder mit einer weiteren Schicht, bspw. einer Phosphat-Schicht, Zink-Schicht, Zink-Nickel-Schicht oder Siloxan-Schicht versehen, vorliegen. Es wird vermutet, dass insbesondere Si und O für eine gute Haftung der Beschichtung auf Metallen sehr förderlich ist, da hier ionische und elektrostatische Wechselwirkungen auftreten können.

In einer weiteren bevorzugten Ausführungsform ist die Substratschicht eine Kunststoffschicht. Dabei bedeutet der Begriff Kunststoffschicht, dass ein Kunststoff eine Matrix ausbildet. Bevorzugt ist der Kunststoff ein Thermoplast oder Duroplast. Geeignete Kunststoffe sind beispielsweise Thermoplaste, vorzugsweise aus den Klassen Standardthermoplaste, technische Thermoplaste und/oder Hochleistungsthermoplaste. Bevorzugte Thermoplaste sind Polyolefine (Polypropylen, Polyethylen), Polyamide, Polyester (wie Polybutylentherephthalat), Polyphenylensulfide oder Fluorpolymere wie Polytetrafluorethylen, Polyvinylidenfluorid, Perfluoralkoxy-Polymere oder Gemische solcher Polymere. Besonders bevorzugte Thermoplaste sind Polyamide, Polyphenylensulfide, Polyester und Gemische hiervon. Dabei können auch Faser- oder Partikelverstärkte Werkstoffe eingesetzt werden, die auf diesen Kunststoffen basieren. Allgemein kann die Kunststoffmatrix übliche Additive enthalten, insbesondere Füllstoffe. Solche Polymere weisen ausreichende Beständigkeiten auf, um im Plasma mit Beschichtungen auf Basis von Si, C, sowie optional O und H ausgestattet zu werden.

Die Substratschicht kann auch eine anorganische Schicht sein, und dabei insbesondere eine Schicht aus Keramik, Glas oder Oxiden von Metallen oder Halbmetallen, wie Silica.

In einer bevorzugten Ausführungsform ist die Substratschicht als Formkörper und/oder Halbzeug ausgebildet. Formkörper und Halbzeuge sind beides Vormaterialien aus bestimmten Werkstoffen. Formkörper haben eine bestimmte dreidimensionale geometrische Form und Größe, die schon dem Endprodukt ähnelt. Keine Formkörper sind z.B. Bleche, Folien, Profile, Rohre, Schläuche, Endlosfasern oder Seile. Diese Produkte werden als Halbzeuge bezeichnet. Halbzeuge haben eine einfache geometrische Form, die in der Fachwelt oft als 2-bis 2,5 dimensional bezeichnet wird, und dienen als Rohmaterial für weitere Fertigungsschritte. Erfindungsgemäß bevorzugt sind Formkörper.

Die Haftvermittlerschicht ist durch plasmagestützte chemische Gasphasenabscheidung (PE-CVD) erhältlich. Dabei wird die Haftvermittlerschicht durch PE-CVD auf das Substrat aufgetragen. Die Verbindung mit der Polymerschicht erfolgt erst nach Abschluss des Plasmaverfahrens. Die Haftvermittlerschicht enthält die Elemente Si, C, H und optional O. Da die Struktur dabei durch Si, C und, wenn vorhanden, O geprägt wird, während die H Atome endständig an die anderen Elemente angehängt sind, kann die Haftvermittlerschicht im Rahmen dieser Anmeldung auch als Haftvermittlerschicht auf Basis von Si, C und optional O bezeichnet werden. Die Haftvermittlerschicht kann auch weitere Elemente enthalten, wie N, S oder Halogene, wie Cl oder F.

Verfahren zur Erzeugung von Beschichtungen auf Substraten mittels PE-CVD sind im Stand der Technik bekannt und beschrieben. Lediglich beispielsweise wird auf die einleitend erörterten Druckschriften verwiesen. Generell werden Beschichtungen im Plasma aus Si, C, H und optional O erhalten, wenn dem Plasma gasförmige oder fein vernebelte flüssige, bspw. dampfförmige, Vorläufermaterialien, die Vorläuferverbindungen enthalten, zugeführt werden, die Si-, C-, H- und optional O-Atome aufweisen. Die Vorläuferverbindungen werden im Plasma aktiviert und bilden auf der Substratoberfläche vernetzte Schichten aus. Mit Vorläuferverbindung werden Verbindungen bezeichnet, deren Bestandteile zum Schichtwachstum beitragen. Keine Vorläuferverbindungen sind daher Trägergase oder Inertgase, die zusätzlich in dem Gemisch enthalten sein können. Plasma-Beschichtungen unterscheiden sich signifikant von Beschichtungen mit vergleichbaren Zusammensetzungen, die beispielsweise durch herkömmliche Polymerisationsverfahren und Vernetzungsverfahren erhalten werden. Plasma-Beschichtungen bilden charakteristische, nicht stöchiometrische Strukturen aus, die nicht ohne weiteres durch eine chemische Formel beschreibbar sind.

Die Haftvermittlerschicht wird durch einen PE-CVD-Prozess erhalten, wobei mindestens teilweise ein Vorläufermaterial eingesetzt wird, das mindestens eine siliciumorganische Verbindung als Vorläuferverbindung enthält. Darüber hinaus kann das Vorläufermaterial auch als Gemisch vorliegen, in dem die silciumorganische Verbindung im Gemisch mit mindestens einer weiteren Vorläuferverbindung, bspw. mindestens einem ungesättigten Kohlenwasserstoff vorliegt. Ferner kann das Vorläufermaterial zwei, drei oder mehr siliciumorganische Verbindungen enthalten. Bevorzugt enthält das Vorläufermaterial neben der siliciumorganischen Verbindung keine weiteren Vorläuferverbindungen.

Überraschenderweise wurde gefunden, dass mit einem solchen Vorläufermaterial eine besonders stabile haftende Verbindung in Kombination mit einer Polymerschicht, die eine Shore Härte zwischen 60 und 95 Shore A aufweist, erreicht werden kann. Insbesondere ist die Stabilität der Verbundmaterialien höher als die von vergleichbaren Verbundmaterialien, bei denen die Polymerschicht weicher ist.

Erfindungsgemäß wird die Haftvermittlerschicht durch plasmagestützte chemische Gasphasenabscheidung (PE-CVD) erhalten. Die PE-CVD ist ein Beschichtungsverfahren aus der Kategorie der chemischen Gasphasenabscheidung (engl. Chemical Vapour Deposition, CVD). Bei der CVD wird allgemein eine Beschichtung, d.h. ein Feststoff, durch eine chemische Reaktion aus der Gas- bzw. der Dampfphase auf einer Oberfläche abgeschieden. Bei der PE-CVD erfolgt die Schichtabscheidung aus einem schichtbildenden Plasma. Dazu wird ein Gas, Dampf und/oder Aerosol, das das Vorläufermaterial enthält, in den Plasmazustand versetzt. Hierzu kann direkt aus dem Gas, Dampf und/oder Aerosol ein Plasma gezündet werden. Alternativ kann das Vorläufermaterial enthaltende Gas, Dampf und/oder Aerosol einem bereits gezündeten nicht-schichtbildenden Plasma zugeführt werden. Ein nichtschichtbildendes Plasma basiert beispielsweise auf inerten und/oder anorganischen Gasen, z.B. Luft, Sauerstoff, Stickstoff oder Edelgasen. Im schichtbildenden Plasma können auch mehrere Vorläuferverbindungen gleichzeitig oder nacheinander zum Einsatz kommen.

In der Plasmaphase wird das Vorläufermaterial durch Wechselwirkungen mit den aktiven Bestandteilen des Plasmas (freie Elektronen, elektromagnetische Energie, Ionen, Radikale, Neutralteilchen) angeregt und fragmentiert und reagiert in der Regel zum Teil in der Plasmaphase, zum Teil an den angrenzenden Oberflächen zu einer Beschichtung. Der Ort der Schichtabscheidung und insbesondere die Eigenschaften der Beschichtungen werden wesentlich durch die Parameter des Beschichtungsprozesses gesteuert.

Die PE-CVD kann im Vakuum durchgeführt werden. Mithin kann die plasmagestützte chemische Gasphasenabscheidung im erfindungsgemäßen Verfahren eine Vakuum-PE-CVD sein. Dies ist u.a. wegen der niedrigeren Prozesstemperaturen vorteilhaft, insbesondere für die Beschichtung von temperaturempfindlichen Materialien wie Kunststoffen. Bei der Vakuum-PE-CVD wird üblicherweise eine Reaktionskammer verwendet, die anfangs auf unter 1 Pascal Prozessdruck evakuiert wird. Anschließend werden die Prozessgase, d.h. Vorläufermaterial und ggf. Inertgas, zugegeben und durch die Anregung mit elektromagnetischer Strahlung, bspw. bei Radiofrequenz oder Mikrowelle, in den Plasmazustand überführt. Die wesentlichen Prozessparameter für die Abscheidung einer Haftvermittlerschicht sind die Menge und das Verhältnis der Prozessgase, die Prozessleistung, der Prozessdruck und die Prozesszeit. Bei einem PE-CVD-Prozess im Vakuum können die Prozessparameter über die gesamte Prozessdauer auch zeitlich variiert werden. Besonders bevorzugt ist ein PE-CVD-Prozess mit zunächst nicht-schichtbildenden Prozessgasen zur Aktivierung der Oberflächen, der dann in einen Prozess mit dem schichtbildenden Vorläufermaterial und ggf. Inertgasen übergeht. Das Vorläufermaterial kann hierbei aus ein oder mehreren Vorläuferverbindungen bestehen, deren Menge und Verhältnis auch zeitlich variiert werden kann. Werden die Prozessparameter bei der PE-CVD-Beschichtung konstant gehalten, so wird ein homogenes Ein-SchichtSystem auf dem zu beschichtenden Werkstück erzeugt. Werden die genannten Prozessparameter über die Prozessdauer variiert, kann ein Mehrschicht-System auf dem zu beschichtenden Werkstück erzeugt werden.

In einer bevorzugten Ausführungsform wird die PE-CVD bei Atmosphärendruck durchgeführt. Mithin ist die plasmagestützte chemische Gasphasenabscheidung im erfindungsgemäßen Verfahren in einer Ausführungsform ein Atmosphärendruck-PE-CVD. Dies ist wegen der Möglichkeit zur lokalen Beschichtung und zur inline-Integration des Beschichtungsprozesses in bestehende Prozessketten vorteilhaft.

Bevorzugt wird hier die Beschichtung mit einer Plasmadüse abgeschieden. In der Düse wird aus einem Gasstrom eines oder mehrerer Inertgase ein Plasma erzeugt. Die Plasmaerzeugung kann, ohne darauf beschränkt zu sein, in einer Bogenentladung oder in einer dielektrisch behinderten Barriere-Entladung umgesetzt werden. In der Regel tritt das Prozessgas am oberen Ende des Reaktionsraums in der Düse ein, wird dann im Reaktionsraum zum Plasma angeregt und tritt am unteren Ende der Düse als Plasma aus der aktiven Plasmazone aus. Am unteren Ende der Düse wird dem Plasmagas üblicherweise das Vorläufermaterial als Gas, Dampf und/oder Aerosol zugeführt. Die Oberfläche, die von dem aus der Düse austretenden Plasma überstrichen wird, kann hierdurch beschichtet werden. Eine größere Fläche kann durch die Bewegung der Düse über die Werkstückoberfläche beschichtet werden. Die wesentlichen Prozessparameter sind hier die jeweiligen Gasströme und Mengen an Vorläufermaterial, die Prozessleistung und insbesondere der Abstand der Düse zum Werkstück sowie die Verfahrgeschwindigkeit der Düse über der zu beschichtenden Oberfläche. Werden während der Überfahrt der Düse über das Werkstück alle Prozessparameter konstant gehalten, so handelt es sich bei den abgeschiedenen Schichten um Ein-Schicht-Systeme. Stufen-Gradienten können durch die wiederholte Überfahrt mit geänderten Prozessparametern erzeugt werden.

Die mittels PE-CVD abgeschiedenen Schichten sind in der Regel dreidimensional hoch vernetzt und nicht stöchiometrisch zusammengesetzt. Die Schichteigenschaften werden im Wesentlichen durch die Wahl der Prozessparameter beeinflusst. Üblicherweise reagieren mittels PE-CVD abgeschiedene Schichten nach Ende des Prozesses noch nach. Beispielsweise können in der Schicht gefangene freie Radikale mit dem Luftsauerstoff reagieren, sodass auch in Beschichtungen aus Sauerstoff-freien Prozessen Sauerstoff nachgewiesen werden kann.

Allgemein ist dabei aber zu beachten, dass eine genaue Struktur von Schichten, die durch PE-CVD erzeugt werden, nur schwer oder näherungsweise ermittelbar ist. Da im Plasma eine Vielzahl von reaktiven Radikalen, Ionen, Neutralteilchen und Verbindungen auf eine Vielzahl von Weisen reagieren und abgeschieden werden können, weisen Plasma-Schichten auf molekularer Ebene keine genau definierten Strukturen auf. So können die Beschichtungen beispielsweise funktionelle Gruppen wie Kohlenstoffdoppelbindungen, Acrylat-, Carboxy, Amino-, Alkohol-, Keto-, Carbonyl-, Mercapto-Gruppen oder radikalische Gruppen aufweisen. Daher ist es in dem technischen Gebiet üblich und auch sinnvoll, Plasma-Beschichtungen durch die Vorläuferverbindungen zu charakterisieren.

Im Rahmen dieser Anmeldung bedeutet "siliciumorganische Verbindung" typischerweise, dass die Verbindung Si, C, H und gegebenenfalls weitere Elemente, wie bevorzugt O, S und/oder N enthält. Außerdem sind im Rahmen der vorliegenden Erfindung davon auch Silane umfasst. Die siliciumorganische Verbindung kann auch Halogene als weitere Elemente enthalten. Die siliciumorganische Verbindung ist bevorzugt eine niedermolekulare, also nichtpolymere Verbindung. Dabei bedeutet niedermolekular bevorzugt mittlere Molmassen unter 1000 g/mol, vorzugsweise 50 bis 1000 g/mol, noch bevorzugter unter 800 g/mol, vorzugsweise 50 bis 800 g/mol, noch bevorzugter unter 600 g/mol, vorzugsweise 50 bis 600 g/mol, gemessen mittels Massenspektroskopie. Bevorzugt umfasst die siliciumorganische Verbindung ein Silan, ein Organosilan, ein Siloxan, ein Alkoxysilan und/oder Gemische hiervon. Bevorzugter umfasst die siliciumorganische Verbindung ein Organosilan, ein Siloxan, ein Alkoxysilan und/oder Gemische hiervon. Besonders bevorzugt sind Siloxane oder Alkoxysilane und/oder Gemische hiervon.

Besonders bevorzugt ist die siliciumorganische Verbindung ein Silan, ein Organosilan, eine Verbindung der allgemeinen Formel (I)

Y-[O-Si(-X-Z)ₚ(OY)ₘ]ₙ-O-Y

oder eine vernetzte Form davon, oder eine cyclische Form davon, worin
für jedes betreffende Si-Atom m gleich 0 bis 2 ist, und p gleich 2-m ist,
   - Z: ausgewählt ist unter
   Amino-, vorzugsweise primärem Amino- (-NH₂), sekundärem Amino-, insbesondere (-NHCH₃), tertiärem Amino-, insbesondere (-N(CH₃)₂), (-N(CH₂CH₃)₂);
   C₁-C₁₄-Carboxyl- (d.h. -C(=O)OR¹ mit R¹ = C¹- bis C¹⁴-Rest), vorzugsweise (-C(=O)OR¹) mit R¹ = C₁-C₁₂-Alkyl, C₂-C₁₂-Alkenyl, C₅-C₁₂ Aryl, C₁-C₁₂ Acryl, insbesondere C₃-C₁₂ Acryloxy, C₃-C₁₂ Acrylamino, C₄-C₁₂-Methacryl, insbesondere C₄-C₁₂-Methacryloxy, C₄-C₁₂-Methacrylamino, C₄-C₁₂-Maleat, C₄-C₁₂-Maleatanhydrid, C₄-C₁₂-Maleinimid; C₁-C₁₂-Carbonyl, insbesondere R³C(=O)- mit R³=H, C₁-C₃-Alkyl oder C₁-C₁₂-Aryl, dabei insbesondere Phenyl;
   C₁-C₁₄-Oxycarbonyl- (d.h. -O(C=O)R² mit R² = C₁- bis C¹⁴-Rest), vorzugsweise (-O(C=O)R²) mit R² = C₁-C₁₂-Alkyl, C₂-C₁₂-Alkenyl, dabei insbesondere C₂-Alkenyl, C₅-C₁₂-Aryl, C₃-C₁₂-Acryl, insbesondere C₃-C₁₂-Acryloxy und C₃-C₁₂-Acrylamino, C₄-C₁₂-Methacryl, insbesondere C₄-C₁₂-Methacryloxy, C₄-C₁₂-Methacrylamino, C₄-C₁₂-Maleat, C₄-C₁₂-Maleatanhydrid, C₄-C₁₂-Maleinimid, C₁-C₁₂-Carbonyl, insbesondere R³C(=O)- mit R³=H, C₁-C₃-Alkyl, C₁-C₁₂-Aryl, dabei insbesondere Phenyl;
   C1-C14-Amid- (d.h. -NH(C=O)R² mit R² = C₁- bis C¹⁴-Rest), vorzugsweise (-NH(C=O)R²) mit R² = C₁-C₁₂-Alkyl, C₂-C₁₂-Alkenyl, dabei insbesondere C₂-Alkenyl, C₅-C₁₂-Aryl, C₃-C₁₂-Acryl, insbesondere C₃-C₁₂-Acryloxy und C₃-C₁₂-Acrylamino, C₄-C₁₂-Methacryl, insbesondere C₄-C₁₂-Methacryloxy, C₄-C₁₂-Methacrylamino, C₄-C₁₂-Maleat, C₄-C₁₂-Maleatanhydrid, C₄-C₁₂-Maleinimid, C₁-C₁₂-Carbonyl, insbesondere R³C(=O)- mit R³=H, C₁-C₃-Alkyl, C₁-C₁₂-Aryl, dabei insbesondere Phenyl;
   C₁-C₁₂-Alkyl, vorzugsweise Methyl, Ethyl, Propyl;
   C₂-C₁₂-Alkenyl, vorzugsweise C₂-C₆-Alkenyl, insbesondere Vinyl;
   C₁-C₁₂-Aldehyd, C₁-C₁₂-Peroxo, C₁-C₁₂-Mercapto, C₁-C₁₂-Thiocyanato, C₃-C₁₂-Glycidylether, C₂-C₁₂-Epoxy-, insbesondere C₃-C₁₂-Acryloxy-, C₄-C₁₂-Methacryloxy-;
   - X: einen Linker darstellt, vorzugsweise ausgewählt aus C₁-C₅-Alkylen, insbesondere Methylen, Ethylen, Propylen, C₅-C₈-Arylen, C₃-C₆-Ether, C₃-Cs-Thioether;
   - Y: unabhängig voneinander für C₁-C₅-Alkyl steht,
   - n: für eine ganze Zahl von 1 bis 100, bevorzugt 1 bis 15 steht,
und/oder Gemische hiervon.

Besonders bevorzugt ist n = 1.

Silane sind chemische Verbindungen, die aus einem Silicium-Grundgerüst und Wasserstoff bestehen. Erfindungsgemäß einsetzbare Silane umfassen Silane, die aus einem Silicium-Grundgerüst und Wasserstoff bestehen. Silane können einen verzweigten (iso- und neo-Silane) oder unverzweigten (n-Silane) Aufbau haben. Die allgemeine Summenformel der acyclischen (offenkettigen, auch catena-Silane genannten) Silane lautet SiₙH₂ₙ₊₂. Ringförmige Silicium-WasserstoffVerbindungen nennt man Cyclosilane (allgemeine Summenformel: SiₙH₂ₙ).

Bevorzugt weist das Silan als Vorläuferverbindung 1 bis 6 Siliciumatome, besonders bevorzugt 1 bis 3 Siliciumatome auf. Insbesondere ist das Silan ausgewählt aus Disilan (Si₂H₆) oder Trisilan (Si₃H₈).

Organosilane sind organo-substituierte Silane, die ein Silicium-Grundgerüst und Wasserstoff umfassen, in dem der Wasserstoff teilweise durch organische Gruppen ersetzt ist, oder bei denen der Wasserstoff vollständig durch organische Gruppen ersetzt ist. Jedes Siliciumatom kann an ein bis vier Organo-Gruppen gebunden sein. Organo-substituierte Silane können einen verzweigten (iso- und neo-Silane) oder unverzweigten (n-Silane) Aufbau haben.

In einer bevorzugten Ausführungsform weist das organo-substituierte Silan die Formel SiₙR₂ₙ₊₂ auf, in der n eine ganze Zahl von 1 bis 15 ist, und R gleich R¹, R², R³ und R⁴ ist, wobei R¹, R², R³ und R⁴ unabhängig voneinander ausgewählt sind aus C₁-C₁₂ Alkyl, C₁-C₁₂ Alkenyl oder Wasserstoff, wobei mindestens ein Substituent R kein Wasserstoff ist. Bevorzugt ist das Organosilan Tetramethylsilan (TMS).

Besonders bevorzugt ist die siliciumorganische Verbindung Tetramethylsilan (TMS). Verfahren zur Herstellung von Plasma-Beschichtungen mit TMS sind im Stand der Technik bekannt. TMS eignet sich wegen der physikalischen und chemischen Eigenschaften besonders gut zur Erzeugung von Plasma-Beschichtungen. Es eignet sich auch in Gemischen mit ungesättigten Kohlenwasserstoffen zur Erzeugung von Haftvermittlerschichten.

Alkoxysilane sind Organosilane, die mindestens einen Alkoxysubstituenten umfassen, wobei die Alkoxysubstituenten vorzugsweise C₁-C₁₂ Alkoxy, insbesondere C₁-C₅ Alkoxy sind.

Besonders bevorzugt ist das Alkoxysilan eine Verbindung der allgemeinen Formel (I)

Y-[O-Si(-X-Z)ₚ(OY)ₘ]ₙ-O-Y

oder eine vernetzte Form davon, oder eine cyclische Form davon, worin
für jedes betreffende Si-Atom m gleich 0 bis 2 ist, und p gleich 2-m ist,
   - Z: ausgewählt ist unter
   Amino-, vorzugsweise primärem Amino- (-NH₂), sekundärem Amino-, insbesondere (-NHCH₃), tertiärem Amino-, insbesondere (-N(CH₃)₂), (-N(CH₂CH₃)₂);
   C₁-C₁₄-Carboxyl- (d.h. -C(=O)OR¹ mit R¹ = C¹- bis C¹⁴-Rest), vorzugsweise (-C(=O)OR¹) mit R¹ = C₁-C₁₂-Alkyl, C₂-C₁₂-Alkenyl, C₅-C₁₂ Aryl, C₁-C₁₂ Acryl, insbesondere C₃-C₁₂ Acryloxy, C₃-C₁₂ Acrylamino, C₄-C₁₂-Methacryl, insbesondere C₄-C₁₂-Methacryloxy, C₄-C₁₂-Methacrylamino, C₄-C₁₂-Maleat, C₄-C₁₂-Maleatanhydrid, C₄-C₁₂-Maleinimid; C₁-C₁₂-Carbonyl, insbesondere R³C(=O)- mit R³=H, C₁-C₃-Alkyl oder C₁-C₁₂-Aryl, dabei insbesondere Phenyl;
   C₁-C₁₄-Oxycarbonyl- (d.h. -O(C=O)R² mit R² = C₁- bis C¹⁴-Rest), vorzugsweise (-O(C=O)R²) mit R² = C₁-C₁₂-Alkyl, C₂-C₁₂-Alkenyl, dabei insbesondere C₂-Alkenyl, C₅-C₁₂-Aryl, C₃-C₁₂-Acryl, insbesondere C₃-C₁₂-Acryloxy und C₃-C₁₂-Acrylamino, C₄-C₁₂-Methacryl, insbesondere C₄-C₁₂-Methacryloxy, C₄-C₁₂-Methacrylamino, C₄-C₁₂-Maleat, C₄-C₁₂-Maleatanhydrid, C₄-C₁₂-Maleinimid, C₁-C₁₂-Carbonyl, insbesondere R³C(=O)- mit R³=H, C₁-C₃-Alkyl, C₁-C₁₂-Aryl, dabei insbesondere Phenyl;
   C1-C14-Amid- (d.h. -NH(C=O)R² mit R² = C₁- bis C¹⁴-Rest), vorzugsweise (-NH(C=O)R²) mit R² = C₁-C₁₂-Alkyl, C₂-C₁₂-Alkenyl, dabei insbesondere C₂-Alkenyl, C₅-C₁₂-Aryl, C₃-C₁₂-Acryl, insbesondere C₃-C₁₂-Acryloxy und C₃-C₁₂-Acrylamino, C₄-C₁₂-Methacryl, insbesondere C₄-C₁₂-Methacryloxy, C₄-C₁₂-Methacrylamino, C₄-C₁₂-Maleat, C₄-C₁₂-Maleatanhydrid, C₄-C₁₂-Maleinimid, C₁-C₁₂-Carbonyl, insbesondere R³C(=O)- mit R³=H, C₁-C₃-Alkyl, C₁-C₁₂-Aryl, dabei insbesondere Phenyl;
   C₁-C₁₂-Alkyl, vorzugsweise Methyl, Ethyl, Propyl;
   C₂-C₁₂-Alkenyl, vorzugsweise C₂-C₆-Alkenyl, insbesondere Vinyl;
   C₁-C₁₂-Aldehyd, C₁-C₁₂-Peroxo, C₁-C₁₂-Mercapto, C₁-C₁₂-Thiocyanato, C₃-C₁₂-Glycidylether, C₂-C₁₂-Epoxy-, insbesondere C₃-C₁₂-Acryloxy-, C₄-C₁₂-Methacryloxy-;
   - X: einen Linker darstellt, vorzugsweise ausgewählt aus C₁-C₅-Alkylen, insbesondere Methylen, Ethylen, Propylen, C₅-C₈-Arylen, C₃-C₆-Ether, C₃-Cs-Thioether;
   - Y: unabhängig voneinander für C₁-C₅-Alkyl steht,
   - n: für 1 steht.

Besonders bevorzugt ist die siliciumorganische Verbindung ein Alkoxysilan ausgewählt unter Tetraethylorthosilikat (TEOS), (3-Aminopropyl)triethoxysilan (APTES), Vinyltriethoxysilan (VEOS), 3-Methacryloxypropyltrimethoxysilan (MEMO), (3-Glycidyloxypropyl)trimethoxysilan (GLYMO), (3-Mercaptopropyl)trimethoxysilan (MTMO), 3-Thiocyanatopropyltriethoxysilane (TCPS) und Gemischen hiervon.

Besonders bevorzugt ist die siliciumorganische Verbindung ein Alkoxysilan ausgewählt unter Aminopropyl)triethoxysilan (APTES), Vinyltriethoxysilan (VEOS), 3-Methacryloxypropyltrimethoxysilan (MEMO), 3-Thiocyanatopropyltriethoxysilane (TCPS) und/ oder (3-Mercaptopropyl)trimethoxysilan (MTMO).

Weiter besonders bevorzugt ist die siliciumorganische Verbindung ein Alkoxysilan ausgewählt aus Vinyltriethoxysilan (VEOS), 3-Methacryloxypropyltrimethoxysilan (MEMO) und/ oder (3-Mercaptopropyl)trimethoxysilan (MTMO), 3-Thiocyanatopropyltriethoxysilane (TCPS) und Gemischen hiervon .

Siloxane sind chemische Verbindungen mit der allgemeinen Formel R₃Si-[O-SiR₂]ₙ-O-SiR₃, wobei R unabhängig voneinander bevorzugt Wasserstoffatome, Alkylgruppen, Arylgruppen oder Alkoxygruppen sein können und n in einer bevorzugten Ausführungsform gleich 0 bis 4 ist, und in einer anderen bevorzugten Ausführungsform größer 10 ist, und dabei insbesondere höchstens 100 ist. Im Gegensatz zu den Silanen sind die Siliciumatome nicht untereinander, sondern durch genau ein Sauerstoffatom mit ihrem benachbarten Siliciumatom verknüpft: Si-O-Si. Siloxane mit R = CH₃ heißen Polydimethylsiloxane.

Bevorzugt weisen die Siloxane 2 bis 6 Siliciumatome auf. Besonders bevorzugt ist das Siloxan ausgewählt aus Disiloxan, insbesondere Hexamethyldisiloxan (HMDSO), oder Trisiloxane, insbesondere Octamethyltrisiloxan. In einer bevorzugten Ausführungsform ist das Siloxan HMDSO. HMDSO wird in seinen physikalischen und chemischen Eigenschaften häufig zur Herstellung von siliciumhaltigen Beschichtungen im Plasma eingesezt, weil es vergleichsweise kostengünstig ist und aufgrund des hohen Dampfdrucks leicht ins Plasma zu überführen ist.

In einer besonders bevorzugten Ausführungsform umfasst die siliciumorganische Verbindung ein Siloxan der allgemeinen Formel (I)

Y-[O-Si(-X-Z)ₚ(OY)ₘ]ₙ-O-Y

oder eine vernetzte Form davon, oder eine cyclische Form davon auf, worin
für jedes betreffende Si-Atom m gleich 0 bis 2 ist, und p gleich 2-m ist,
   - Z: ausgewählt ist unter
   Amino-, vorzugsweise primärem Amino- (-NH₂), sekundärem Amino-, insbesondere (-NHCH₃), tertiärem Amino-, insbesondere (-N(CH₃)₂), (-N(CH₂CH₃)₂);
   C₁-C₁₄-Carboxyl- (d.h. -C(=O)OR¹ mit R¹ = C¹- bis C¹⁴-Rest), vorzugsweise (-C(=O)OR¹) mit R¹ = C₁-C₁₂-Alkyl, C₂-C₁₂-Alkenyl, C₅-C₁₂ Aryl, C₁-C₁₂ Acryl, insbesondere C₃-C₁₂ Acryloxy, C₃-C₁₂ Acrylamino, C₄-C₁₂-Methacryl, insbesondere C₄-C₁₂-Methacryloxy, C₄-C₁₂-Methacrylamino, C₄-C₁₂-Maleat, C₄-C₁₂-Maleatanhydrid, C₄-C₁₂-Maleinimid; C₁-C₁₂-Carbonyl, insbesondere R³C(=O)- mit R³=H, C₁-C₃-Alkyl oder C₁-C₁₂-Aryl, dabei insbesondere Phenyl;
   C₁-C₁₄-Oxycarbonyl- (d.h. -O(C=O)R² mit R² = C₁- bis C¹⁴-Rest), vorzugsweise (-O(C=O)R²) mit R² = C₁-C₁₂-Alkyl, C₂-C₁₂-Alkenyl, dabei insbesondere C₂-Alkenyl, C₅-C₁₂-Aryl, C₃-C₁₂-Acryl, insbesondere C₃-C₁₂-Acryloxy und C₃-C₁₂-Acrylamino, C₄-C₁₂-Methacryl, insbesondere C₄-C₁₂-Methacryloxy, C₄-C₁₂-Methacrylamino, C₄-C₁₂-Maleat, C₄-C₁₂-Maleatanhydrid, C₄-C₁₂-Maleinimid, C₁-C₁₂-Carbonyl, insbesondere R³C(=O)- mit R³=H, C₁-C₃-Alkyl, C₁-C₁₂-Aryl, dabei insbesondere Phenyl;
   C1-C14-Amid- (d.h. -NH(C=O)R² mit R² = C₁- bis C¹⁴-Rest), vorzugsweise (-NH(C=O)R²) mit R² = C₁-C₁₂-Alkyl, C₂-C₁₂-Alkenyl, dabei insbesondere C₂-Alkenyl, C₅-C₁₂-Aryl, C₃-C₁₂-Acryl, insbesondere C₃-C₁₂-Acryloxy und C₃-C₁₂-Acrylamino, C₄-C₁₂-Methacryl, insbesondere C₄-C₁₂-Methacryloxy, C₄-C₁₂-Methacrylamino, C₄-C₁₂-Maleat, C₄-C₁₂-Maleatanhydrid, C₄-C₁₂-Maleinimid, C₁-C₁₂-Carbonyl, insbesondere R³C(=O)- mit R³=H, C₁-C₃-Alkyl, C₁-C₁₂-Aryl, dabei insbesondere Phenyl;
   C₁-C₁₂-Alkyl, vorzugsweise Methyl, Ethyl, Propyl;
   C₂-C₁₂-Alkenyl, vorzugsweise C₂-C₆-Alkenyl, insbesondere Vinyl;
   C₁-C₁₂-Aldehyd, C₁-C₁₂-Peroxo, C₁-C₁₂-Mercapto, C₁-C₁₂-Thiocyanato, C₃-C₁₂-Glycidylether, C₂-C₁₂-Epoxy-, insbesondere C₃-C₁₂-Acryloxy-, C₄-C₁₂-Methacryloxy-;
   - X: einen Linker darstellt, vorzugsweise ausgewählt aus C₁-C₅-Alkylen, insbesondere Methylen, Ethylen, Propylen, C₅-C₈-Arylen, C₃-C₆-Ether, C₃-Cs-Thioether;
   - Y: unabhängig voneinander für C₁-C₅-Alkyl steht,
   - n: für eine ganze Zahl von 2 bis 100, bevorzugt 2 bis 15 steht.

In einer besonders bevorzugten Ausführungsform umfasst die siliciumorganische Verbindung ein Siloxan der allgemeinen Formel (I)

Y-[O-Si(-X-Z)ₚ(OY)ₘ]ₙ-O-Y

oder eine vernetzte Form davon, oder eine cyclische Form davon auf, worin
für jedes betreffende Si-Atom m gleich 0 bis 2 ist, und p gleich 2-m ist,
   - Z: ausgewählt ist unter
   primärem Amino (NH₂),
   C₁-C₁₄-Oxycarbonyl, vorzugsweise (-O(C=O)R²) mit R² = C₁-C₁₂-Alkyl, C₂-C₁₂-Alkenyl, C₅-C₁₂-Aryl, C₃-C₁₂ Acryl, insbesondere C₃-C₁₂-Acryloxy und C₃-C₁₂-Acrylamino, C₄-C₁₂-Methacryl, insbesondere C₄-C₁₂-Methacryloxy, C₄-C₁₂-Methacrylamino,
   C₁-C₁₂-Alkyl,
   Vinyl,
   C₁-C₁₂-Mercapto, C₁-C₁₂-Thiocyanato, C₃-C₁₂-Glycidylether, C₃-C₁₂-Acryloxy und C₄-C₁₂-Methacryloxy,
   - X: einen Linker darstellt, vorzugsweise ausgewählt aus C₁-C₅-Alkylen, insbesondere Methylen, Ethylen, Propylen, C₅-C₈-Arylen, C₃-C₆-Ether, C₃-C₆-Thioether,
   - Y: unabhängig voneinander für C₁-C₅-Alkyl stehen,
   - n: für eine ganze Zahl von 2 bis 100, bevorzugt 2 bis 15 steht.

Die aliphatischen Reste können geradkettig oder verzweigt sein.

Besonders bevorzugt ist die siliciumorganische Verbindung ausgewählt unter
- Alkoxysilan ausgewählt aus Tetraethylorthosilikat (TEOS), (3-Aminopropyl)triethoxysilan (APTES), Vinyltriethoxysilan (VEOS), 3-Methacryloxypropyltrimethoxysilan (MEMO), (3-Glycidyloxypropyl)trimethoxysilan (GLYMO), (3-Mercaptopropyl)trimethoxysilan (MTMO), 3-Thiocyanatopropyltriethoxysilane (TCPS),
- Siloxan, ausgewählt aus Disiloxan, insbesondere Hexamethyldisiloxan (HMDSO), und Octamethyltrisiloxan,
- Silan, ausgewählt aus Disilan (Si₂H₆) und Trisilan (Si₃H₈)
- Organosilan ausgewählt aus Tetramethylsilan (TMS), und
- Gemischen hiervon.

Besonders bevorzugt ist die siliciumorganische Verbindung ausgewählt unter Tetraethylorthosilikat (TEOS), (3-Aminopropyl)triethoxysilan (APTES), Vinyltriethoxysilan (VEOS), 3-Methacryloxypropyltrimethoxysilan (MEMO), (3-Glycidyloxypropyl)trimethoxysilan (GLYMO), (3-Mercaptopropyl)trimethoxysilan (MTMO), 3-Thiocyanatopropyltriethoxysilane (TCPS), Hexamethyldisiloxan (HMDSO), Tetramethylsilan (TMS), Disiloxan oder Octamethyltrisiloxan und Gemischen hiervon.

Noch bevorzugter ist die siliciumorganische Verbindung ausgewählt unter Tetraethylorthosilikat (TEOS), (3-Aminopropyl)triethoxysilan (APTES), Vinyltriethoxysilan (VEOS), 3-Methacryloxypropyltrimethoxysilan (MEMO), (3-Glycidyloxypropyl)trimethoxysilan (GLYMO), (3-Mercaptopropyl)trimethoxysilan (MTMO), 3-Thiocyanatopropyltriethoxysilane (TCPS), Tetramethylsilan (TMS) und Gemischen hiervon.

Noch bevorzugter ist die siliciumorganische Verbindung ausgewählt unter Tetraethylorthosilikat (TEOS), Vinyltriethoxysilan (VEOS), 3-Methacryloxypropyltrimethoxysilan (MEMO), (3-Glycidyloxypropyl)trimethoxysilan (GLYMO), (3-Mercaptopropyl)trimethoxysilan (MTMO), 3-Thiocyanatopropyltriethoxysilane (TCPS), Tetramethylsilan (TMS) und Gemischen hiervon.

In einer Ausführungsform weist das Vorläufermaterial ungesättigte Kohlenwasserstoffe als weitere Vorläuferverbindungen auf. Ungesättigte Kohlenwasserstoffe sind Verbindungen aus C und H, die mindestens eine Doppel-oder Dreifachbindung aufweisen. Erfindungsgemäß werden dabei insbesondere aliphatische Kohlenwasserstoffe eingesetzt. Besonders bevorzugt sind dabei Alkene oder Alkine. Bevorzugt werden dabei Alkene oder Alkine eingesetzt, die 2 bis 6 Kohlenstoffatome, insbesondere 2 bis 4 Kohlenstoffatome aufweisen. Beispielsweise kann der ungesättigte Kohlenwasserstoff ausgewählt sein aus Ethylen (Ethen), Propen, Buten, Penten, Hexen, Cyclohexen, Propylen oder Butylen, oder aus Acetylen (Ethin), Propin oder Butin.

In einer bevorzugten Ausführungsform ist der ungesättigte Kohlenwasserstoff Ethylen oder Acetylen. Ethylen und Acetylen eignen sich wegen ihren physikalischen und chemischen Eigenschaften besonders zur Herstellung von Plasma-Beschichtungen. In einer Ausführungsform ist es bevorzugt, dass Acetylen eingesetzt wird. Wenn Acetylen zusammen mit einer siliciumorganischen Vorläuferverbindung zur Herstellung von Plasma-Haftvermittlerschichten eingesetzt wird, kann eine starke Haftwirkung erzeugt werden. Ohne an eine Theorie gebunden zu sein, könnte dies daran liegen, dass eine solche Haftvermittlerschicht an der Oberfläche einen relativ hohen Anteil ungesättigter Gruppen aufweist, die mit der Polymerschicht vernetzt werden können. Zudem enthalten die Oberflächen solcher Plasma-Beschichtungen oft polare funktionelle Gruppen, wie Carbonyl- oder Carboxygruppen, die durch nachgelagerte Reaktionen mit Luftsauerstoff entstehen und ebenfalls für weitere Reaktionen bereitstehen.

In einer bevorzugten Ausführungsform weist das Vorläufermaterial mindestens eine siliciumorganische Verbindung, ausgewählt aus Tetraethylorthosilikat (TEOS), (3-Aminopropyl)triethoxysilan (APTES), Vinyltriethoxysilan (VEOS), 3-Methacryloxypropyltrimethoxysilan (MEMO), (3-Glycidyloxypropyl)trimethoxysilan (GLYMO), (3-Mercaptopropyl)trimethoxysilan (MTMO), 3-Thiocyanatopropyltriethoxysilane (TCPS), Hexamethyldisiloxan (HMDSO), Tetramethylsilan (TMS) und Gemische hiervon, in Kombination mit mindestens einem ungesättigten Kohlenwasserstoff, insbesondere Ethylen und / oder Acetylen, auf.

Die Haftvermittlerschicht kann eine im Wesentlichen homogene Struktur oder eine heterogene Struktur und/oder Zusammensetzung aufweisen. Die Zusammensetzung der Schicht kann insbesondere über die Dicke der Schicht variieren. Eine homogene Struktur kann erhalten werden, wenn bei der PE-CVD die Verfahrensbedingungen, und dabei auch die Zusammensetzung des Vorläufermaterials, konstant gehalten wird. Eine heterogene Struktur kann erhalten werden, wenn bei der Beschichtung im Plasma die Verfahrensbedingungen, und dabei insbesondere die Zusammensetzung des Vorläufermaterials, verändert wird.

Bei der PE-CVD wird das mindestens eine siliciumorganische Verbindung enthaltende Vorläufermaterial zumindest teilweise eingesetzt. Bei solchen PE-CVD Prozessen kann die Art und Menge der Vorläuferverbindungen im Vorläufermaterial während der Reaktion verändert werden. In diesem Zusammenhang bedeutet "teilweise", dass die PE-CVD so geführt werden kann, dass ein Teil der Haftvermittlerschicht nicht aus dem Vorläufermaterial erzeugt wird. Dies kann vorteilhaft sein, um beispielsweise Gradientenschichten herzustellen.

Bevorzugt wird die Haftvermittlerschicht durch PE-CVD erhalten, bei der während mindestens 30 %, bevorzugt 30 bis 100 %, besonders bevorzugt 50 bis 100 % der Gesamt-Beschichtungszeit das Vorläufermaterial zur Abscheidung der Haftvermittlerschicht verwendet wird.

In einer bevorzugten Ausführungsform wird zur Erzeugung eines Teils der Haftvermittlerschicht ein Vorläufermaterial eingesetzt, das mindestens eine siliciumorganische Verbindung enthält, wobei ein anderer Teil der Haftvermittlerschicht aus ungesättigten Kohlenwasserstoffen oder aus einem Gemisch aus ungesättigten Kohlenwasserstoffen und siliciumorganischer Verbindung hergestellt wird.

In einer weiteren bevorzugten Ausführungsform wird zur Erzeugung der Haftvermittlerschicht ein Vorläufermaterial eingesetzt wird, das ausschließlich aus mindestens einer siliciumorganischen Verbindung besteht. Bevorzugt weist das Vorläufermaterial dabei weitere Vorläuferverbindungen, die keine siliciumorganischen Verbindungen sind, in einem Anteil von weniger als 0,5 Gew.%, bezogen auf das Gesamtgewicht des Vorläufermaterials, auf. Hierdurch wird eine überwiegend homogene Schichtstruktur erzeugt.

In einer weiteren bevorzugten Ausführungsform wird die Plasma-Reaktion mit einem Vorläufermaterial durchgeführt, das ausschließlich aus ungesättigten Kohlenwasserstoffen und mindestens einer siliciumorganischen Verbindung als Vorläuferverbindungen besteht.

In einer weiteren bevorzugten Ausführungsform ist die Haftvermittlerschicht als Gradientenschicht ausgebildet. Der Gradient kann dabei ein kontinuierlicher Gradient oder ein Stufengradient sein. Zur Erzeugung eines kontinuierlichen Gradienten kann die Zusammensetzung des Vorläufermaterials bei dem Vakuum-Plasmaprozess kontinuierlich verändert werden. Zur Herstellung eines Stufengradienten kann die Zusammensetzung des Vorläufermaterials schrittweise verändert werden.

Eine Gradientenschicht kann auch erzeugt werden, wenn die Konzentration des Vorläufermaterials gleich bleibt, aber andere wesentliche Verfahrensparameter, wie die Leistung, Verfahrgeschwindigkeit oder Abstand zur Substratschicht, verändert werden.

In einer bevorzugten Ausführungsform weist die Haftvermittlerschicht eine mittlere Dicke von 20 nm bis 5 µm, noch bevorzugter von 20 bis 950 nm, insbesondere von 20 bis 550 nm auf. Allgemein ist es bevorzugt, dass die Haftvermittlerschicht eine möglichst niedrige Dicke aufweist, und dabei gleichzeitig eine stabile Verbindung der Substratschicht mit der Polymerschicht bewirkt. Die mittlere Schichtdicke wird bevorzugt mittels Rasterelektronenmikroskopie an einem Querschnitt der Probe gemessen. Der Querschnitt wird bevorzugt mithilfe von Strahlen von Argon-Ionen in einem Cross Section Polisher präpariert.

Bevorzugt enthält das Vorläufermaterial, das bei dem PE-CVD-Prozess eingesetzt wird, als Vorläuferverbindungen ausschließlich siliciumorganische Verbindungen oder ausschließlich silciumorganische Verbindungen in Kombination mit ungesättigten Kohlenwasserstoffen. Insbesondere ist bevorzugt, dass das Vorläufermaterial aus einer siliciumorganischen Verbindung, ausgewählt aus HMDSO, TMS, MEMO, MTMO, TCPS, VEOS, GLYMO und/ oder APTES, oder aus einer siliciumorganischen Verbindung, ausgewählt aus HMDSO, TMS, MEMO, MTMO, TCPS, VEOS, GLYMO und/oder APTES in Kombination mit einem ungesättigten Kohlenwasserstoff, vorzugsweise ausgewählt aus Ethylen oder Acetylen, besteht. Erfindungsgemäß wurde gefunden, dass eine Haftvermittlerschicht mit starker Bindungswirkung erhalten werden kann, wenn lediglich diese reaktiven Vorläuferverbindungen eingesetzt werden. Auf diese Weise kann die Haftvermittlerschicht auf einfache Weise aus gut verfügbaren und handhabbaren Vorläuferverbindungen erzeugt werden, wobei eine relativ homogene Haftvermittlerschicht erhalten werden kann.

Die elementare Zusammensetzung der Haftvermittlerschicht wird an der Oberfläche der Schicht insbesondere durch Röntgenphotoelektronenspektroskopie (ESCA, XPS) ermittelt. Die Fourier-Transformations-Infrarotspektrometrie (FTIR) kann ergänzend zur Strukturaufklärung eingesetzt werden, und dabei insbesondere zur Identifizierung funktioneller Gruppen. Falls die Zusammensetzung der Haftvermittlerschicht über die Schichtdicke nicht gleichförmig ist, beispielsweise weil die Schicht einen Gradienten aufweist, kann die Zusammensetzung im Inneren der Schicht beispielsweise durch XPS an schrägen Schnitten ermittelt werden.

Nachfolgend werden bevorzugte Zusammensetzungen der Haftvermittlerschicht beschrieben. In einer bevorzugten Ausführungsform weist mindestens die Oberfläche der Haftvermittlerschicht die jeweilige Zusammensetzung auf. Dabei lässt sich die Zusammensetzung der Haftvermittlerschicht an der Oberfläche, insbesondere bis zu einer Tiefe von 10 nm, auf einfache Weise mittels XPS ermitteln. Die Zusammensetzung an der Oberfläche ist für die Anbindung an die Polymerschicht von besonders hoher Bedeutung. In einer weiteren Ausführungsform weist die Haftvermittlerschicht insgesamt die genannte Zusammensetzung auf.

Die hier und nachfolgend angegebenen Anteile in Atom-% für die Elemente Si, O und C werden bevorzugt mittels XPS ermittelt. Dabei kann der Anteil an H mittels XPS nicht detektiert werden. Der Rest des Gewichts besteht bevorzugt aus H, und gegebenenfalls weiteren Elemente, wie N, Halogen, wie F oder CI, S oder Metallen, wie Fe. Dabei besteht der Rest bevorzugt aus Wasserstoff und gegebenenfalls weiteren Elemente aus dem Substrat. Es ist bekannt, dass sich bei solchen Verfahren im Plasma Atome oder Moleküle aus der Substratoberfläche ablösen können und in die Plasmabeschichtung übergehen.

So kann bei Beschichtungen auf Kunststoffen oft ein größerer Anteil Kohlenstoff in der Beschichtung nachgewiesen werden und bei Beschichtungen auf fluorhaltigen Polymeren oft ein Anteil Fluor in der Beschichtung nachgewiesen werden.

Bevorzugt ist der Anteil von Si + C + O an der Oberfläche der Haftvermittlerschicht und/oder der Haftvermittlerschicht insgesamt >80 at%, insbesondere >85 at%, 90 at% oder > 95 at% .

Die Oberfläche der Haftvermittlerschicht und/oder die Haftvermittlerschicht insgesamt weisen bevorzugt einen Anteil an Si auf, der zwischen 3 at% und 25 at%, insbesondere zwischen 4 at% und 20 at%, und besonders bevorzugt zwischen 4 at% und 15 at% liegt.

Die Oberfläche der Haftvermittlerschicht und/oder die Haftvermittlerschicht insgesamt weisen bevorzugt einen Anteil an C auf, der insbesondere >25 at.% oder >30 at.% ist. Es ist bevorzugt, dass dabei der Anteil an C zwischen 25 at% und 90 at%, insbesondere zwischen 30 at% und 85 at%, und besonders bevorzugt zwischen 30 at% und 80 at% ist.

Die Oberfläche der Haftvermittlerschicht und/oder die Haftvermittlerschicht insgesamt weisen bevorzugt einen Anteil an O auf, der insbesondere <65 at.% oder <60 at.% ist. Es ist bevorzugt, dass dabei der Anteil an O zwischen 10 at% und 65 at%, insbesondere zwischen 15 at% und 50 at% ist.

Bevorzugt besteht die Oberfläche der Haftvermittlerschicht und/oder die Haftvermittlerschicht insgesamt aus:

| | |
|---|---|
| Si: | 3 at% bis 25 at%, insbesondere 4 at% bis 20 at%, |
| C: | 25 at% bis 90 at%, insbesondere 30 at% bis 85 at%, |
| O: | 7 at% bis 65 at%, insbesondere 15 at% bis 50 at%, |

wobei die Summe aus Si + C + O bevorzugt >80 at%, insbesondere >85 at%, 90 at% oder > 95 at% ist,
wobei der Rest bevorzugt H, N, S und weitere Elemente, bspw. aus dem Substrat sind.

Bevorzugt enthält die Oberfläche der Haftvermittlerschicht und/oder die Haftvermittlerschicht:

| | |
|---|---|
| Si: | 3 at% bis 25 at%, insbesondere 4 at% bis 20 at%, |
| C: | 25 at% bis 90 at%, insbesondere 30 at% bis 85 at%, |
| O: | 7 at% bis 65 at%, insbesondere 15 at% bis 50 at%, |

wobei die Summe aus Si + C + O bevorzugt >80 at%, insbesondere >85 at%, 90 at% oder > 95 at% ist,
wobei der Rest bevorzugt H, N, S und weitere Elemente, bspw. aus dem Substrat sind.

Die Haftvermittlerschicht kann über verschiedene Bindungsmechanismen mit der Polymerschicht verbunden sein, beispielsweise über kovalente, ionische Wechselwirkung, Wasserstoff-Brückenbindungen, Verschlaufungen und/oder Van Der Waals Wechselwirkungen.

Die Haftvermittlerschicht ist bevorzugt kovalent mit der Polymerschicht verbunden. Die kovalente Bindung wird bevorzugt erzeugt, nachdem die Polymerschicht, oder eine Polymerverbindung als Vorläufer der Polymerschicht, auf die Haftvermittlerschicht aufgetragen wurde. Anschließend werden Bedingungen eingestellt, bei denen die Polymerschicht oder die Polymerverbindung mit der Haftvermittlerschicht in einer chemischen Reaktion eine kovalente Bindung eingehen.

Ohne sich auf einen Mechanismus festzulegen, wird vermutet, dass die kovalente Verbindung der Haftvermittlerschicht mit der Polymerschicht über Sauerstoff- und/ oder Kohlenstoff-Radikale erfolgt.

Wenn das Vorläufermaterial ungesättigte Kohlenwasserstoffe enthält, erfolgt die kovalente Verbindung der Haftvermittlerschicht mit der Polymerschicht bevorzugt über C-C Einfachbindungen. Bevorzugt entstehen die C-C-Einfachbindungen dadurch, dass funktionelle Gruppen an der Oberfläche der Haftvermittlerschicht mit funktionellen Gruppen der Polymerschicht reagieren. Bevorzugt sind die funktionellen Gruppen jeweils ungesättigte Kohlenstoffbindungen, insbesondere C-C Doppelbindungen. In einer besonders bevorzugten Ausführungsform weist die Polymerverbindung zur Herstellung der Polymerschicht ungesättigte Kohlenstoffbindungen auf, insbesondere Doppelbindungen, die zu Kohlenstoffeinfachbindungen vernetzbar sind, welche die Haftvermittlerschicht und die Polymerschicht miteinander verbinden.

Ohne sich auf einen Mechanismus festzulegen, wird vermutet, dass die siliciumorganischen Verbindungen und die ungesättigten Kohlenwasserstoffe dahingehend synergistisch wirken, dass einerseits die Siliciumatome auf das dreidimensionale Netzwerk der Kohlenwasserstoff-Plasma-Schichten eine stabilisierende Wirkung haben, indem Eigenspannungen in den Schichten reduziert und somit stabilere Schichten erzeugt werden. Und andererseits kann ein Vorläufermaterial, das ungesättigte Kohlenwasserstoffe enthält, die haftvermittelnde Wirkung von siliciumorganischen Vorläuferverbindungen deutlich verbessern, indem zusätzliche reaktive Stellen in der Beschichtung verfügbar gemacht werden.

In einer bevorzugten Ausführungsform wird die Polymerschicht erhalten, indem eine Polymerverbindung auf die Haftvermittlerschicht aufgetragen und vernetzt wird, wobei beim Vernetzen der Polymerverbindung auch die Haftvermittlerschicht mit der Polymerschicht bevorzugt kovalent verbunden wird.

Dies bedeutet, dass zwei Reaktionen parallel verlaufen, nämlich die Vernetzung der Polymerverbindung unter Erhalt der Polymerschicht, und die Reaktion zu einer stabilen kovalenten Bindung der Haftvermittlerschicht mit der Polymerschicht.

Bevorzugt weisen die Oberfläche der Haftvermittlerschicht und die Polymerverbindung dabei identische oder ähnliche funktionelle Gruppen auf, insbesondere C-C-, C-O- und/ oder ungesättigte Kohlenstoffbindungen.

In einer bevorzugten Ausführungsform erfolgt das Vernetzen der Polymerschicht durch Vulkanisieren. Bevorzugt wird dabei die Polymerschicht mit der Haftvermittlerschicht kovalent verbunden. Allgemein erfolgt die Vulkanisation in Gegenwart von reaktiven Hilfsstoffen und/oder Katalysatoren, welche die Vernetzung bewirken oder unterstützen. Diese Hilfsstoffe und/oder Katalysatoren können der Polymerschicht und/oder der Polymerverbindung vor der Vulkanisation zugesetzt werden. Als Hilfsstoffe zur Vulkanisation werden beispielsweise Schwefel, Peroxide, Metallverbindungen insbesondere Metalloxide, Silane, Amine, Bisphenole, Phenolharze, Maleinsäureanhydrid, ungesättigte Kohlenwasserstoffe oder energiereiche Strahlung eingesetzt. Die Vulkanisation kann durch äußere Einflüsse induziert oder beschleunigt werden, beispielsweise durch Einwirken von Wärme oder Strahlung.

In einer bevorzugten Ausführungsform weist die Haftvermittlerschicht vor Auftragen der Polymerschicht an der Oberfläche ungesättigte Kohlenstoffbindungen auf, insbesondere Kohlenstoff Doppel- oder Dreifachbindungen. Bei der Herstellung von Plasma-Beschichtungen mit ungesättigten Kohlenwasserstoffen können Haftvermittlerschichten erhalten werden, die an der Oberfläche ungesättigte C-C Bindungen aufweisen. Dabei ist es bevorzugt, Ethylen oder Acetylen einzusetzen, wodurch ein relativ hoher Anteil von ungesättigten funktionellen Gruppen an der Oberfläche der Beschichtung erhalten werden kann.

In einer bevorzugten Ausführungsform ist die Polymerverbindung, die zur Herstellung der Polymerschicht eingesetzt wird, eine ungesättigte Verbindung, die insbesondere nicht aromatische Doppelbindungen enthält. Solche Polymerverbindungen können relativ gut vernetzt werden, insbesondere durch Vulkanisieren.

In einer bevorzugten Ausführungsform ist die Polymerschicht eine elastomere Schicht. Elastomere sind formfeste, vernetzte, aber in weiten Bereichen elastisch verformbare Kunststoffe, deren Glasübergangstemperatur (gemessen nach DIN EN ISO 11357-2:2020-08) sich unterhalb der Einsatztemperatur, bevorzugt unterhalb von 22 °C, befindet. Die Polymerschicht ist bevorzugt aus einem Kautschuk erhältlich. Als Kautschuk bezeichnet man weitgehend unvernetzte, vernetzbare, meist amorphe Polymere, deren Glasübergangstemperatur unter 0 °C liegt. Kautschuke eignen sich allgemein zur Herstellung von elastomeren Schichten durch Vernetzen, bspw. durch Vulkanisation, wobei aus den fließbaren Kautschuken unter Zugabe von Hilfsstoffen Elastomere gebildet werden, die gummi-elastisch und nicht mehr fließfähig sind. Kautschuke enthalten Doppelbindungen und können daher auf einfache Weise vernetzt werden und dabei gegebenenfalls mit der Haftvermittlerschicht eine kovalente Verbindung eingehen.

Erfindungsgemäß weist die Polymerschicht eine Shore- Härte, gemessen nach DIN ISO 7619-1: 2021-02, Shore A, 23 °C, von 60 bis 95 Shore A auf. Die Einstellung der Härte kann auf dem Fachmann bekannte Art und Weise vorgenommen werden, bspw. durch geeignete Wahl des Füllstoffgehalts, des Weichmachergehalts, des Anteils an Vernetzungshilfen oder durch geeignete Wahl der Vulkanisationsbedingungen.

Ohne sich auf einen Mechanismus festzulegen, wird vermutet, dass die siliciumorganische Verbindung deshalb eine besonders günstige Wirkung auf die Grenzflächeneigenschaften hat, da im Vergleich zu reinen Kohlenwasserstoffschichten bei siliciumorganischen Vorläuferverbindungen besonders viele funktionelle Gruppen für die Verbindung von Substrat- und Polymerschichten zur Verfügung stehen. Die günstige Wirkung der siliciumorganischen Verbindung wird durch die Kombination mit der Polymerschicht mit einer höheren Shore A-Härte noch verstärkt, weil die Grenzflächenkräfte aufgrund der hohen Härte der Polymerschicht besonders vorteilhaft im Verbund verteilt werden. Ebenfalls vorteilhaft wirken sich dabei auch die intrinsischen Eigenschaften der Haftvermittlerschicht aus, da diese dreidimensional hochvernetzt und ebenfalls vergleichsweise hart ist, was die Verteilung der auf die Grenzflächen wirkenden Kräfte noch weiter verbessert.

In einer bevorzugten Ausführungsform weist die Polymerschicht ein Polymer auf, das erhältlich ist aus Fluorkautschuk (FKM), Ethylen-Propylen-Copolymere, wie Ethylen-Propylen-Dien-Kautschuk (EPDM), Polyacrylat-Kautschuk (ACM), Ethylen-Acrylat-Kautschuk (AEM), Butadien-Kautschuk, wie Acrylnitril-butadienkautschuk (NBR), hydrierte Acrylnitril-butadienkautschuk (HNBR), Styrol-Butadien-Kautschuk (SBR), Silikon-Kautschuke, Naturkautschuk (NR), Chloropren-Kautschuk (CR), Epichlorhydrin-Kautschuk (ECO), Polyurethan und/oder Epoxid-Polymere.

Bevorzugt enthält die Polymerschicht ein oder mehrere der vorgenannten Polymere in einem Anteil von mindestens 70 Gewichtsprozent, noch bevorzugter 80 bis 100 Gewichtsprozent bezogen auf das Gesamtgewicht der Polymere.

Die vorgenannten Polymere sind vorteilhaft, weil sie auf relativ einfache Weise vernetzt und dabei mit der Haftvermittlerschicht verbunden werden können. In einer besonders bevorzugten Ausführungsform weist die Polymerschicht ein Polymer auf, das erhältlich ist aus Fluorkautschuk (FKM), Ethylen-Propylen-Copolymere, wie Ethylen-Propylen-Dien-Kautschuk (EPDM), Polyacrylat-Kautschuk (ACM), Butadien-Kautschuk, wie Acrylnitril-butadienkautschuk (NBR), hydrierte Acrylnitril-butadienkautschuk (HNBR), Silikon-Kautschuke, Naturkautschuk (NR) und/oder Chloropren-Kautschuk (CR). In einer weiteren besonders bevorzugten Ausführungsform weist die Polymerschicht ein Polymer auf, das erhältlich ist aus aus Fluorkautschuk (FKM), Ethylen-Propylen-Copolymere, wie Ethylen-Propylen-Dien-Kautschuk (EPDM), Ethylen-Acrylat-Kautschuk (AEM) und/oder Butadien-Kautschuk, wie Acrylnitril-butadienkautschuk (NBR), hydrierte Acrylnitril-butadienkautschuk (HNBR).

Bevorzugt enthält die Polymerschicht ein oder mehrere der vorgenannten Polymere in einem Anteil von mindestens 70 Gewichtsprozent, noch bevorzugter 80 bis 100 Gewichtsprozent bezogen auf das Gesamtgewicht der Polymere.

In einer bevorzugten Ausführungsform ist die Polymerschicht aus einem Kautschuk erhältlich und weist einen Füllstoffanteil von mindestens 30 pHr, bevorzugt von mindestens 50 pHr auf. Es wurde gefunden, dass die Kombination aus der Haftvermittlerschicht mit Polymerschicht, die aus einem Kautschuk erhältlich ist und einen Füllstoffanteil von mindestens 30, bevorzugt 50 pHr aufweist, besonders gut haftende Verbunde bildet. Bevorzugte Füllstoffe sind Kohlenstoffmodifikationen, Kieselsäuren und/oder mineralische Füllstoffe. Besonders bevorzugte Kohlenstoffmodifikationen sind Ruß, Graphit und/oder Carbon Nanotubes. Besonders bevorzugte mineralische Füllstoffe sind Silikate, Tonerde, Eisenoxide, Titanoxid, Calciumcarbonat, Bariumsulfat, Aluminiumhydroxid, Zinkoxid und/oder Magnesiumhydroxid. Vorteilhaft an der Verwendung der vorgenannten Füllstoffe ist, dass sie eine hohe Härte aufweisen und dadurch insbesondere die Grenzflächeneigenschaften für die Grenzfläche zwischen Haftvermittlerschicht und Polymerschicht durch Annähern der Härte der jeweiligen Komponenten optimiert werden und auf den Verbund wirkenden Kräfte besser im Verbund verteilt werden können.

In einer weiteren bevorzugten Ausführungsform ist die Polymerschicht aus dem Kautschuk FKM erhältlich, und weist einen Füllstoffanteil von mindestens 30 pHr, bevorzugt mindestens 50 pHr auf, und/oder die Polymerschicht ist aus den Kautschuken Ethylen-Propylen-Copolymere, wie Ethylen-Propylen-Dien-Kautschuk (EPDM), Polyacrylat-Kautschuk (ACM), Ethylen-Acrylat-Kautschuk (AEM), Butadien-Kautschuk, wie Acrylnitril-butadienkautschuk (NBR), hydrierte Acrylnitril-butadienkautschuk (HNBR), Styrol-Butadien-Kautschuk (SBR), Silikon-Kautschuke, Naturkautschuk (NR), Chloropren-Kautschuk (CR), Epichlorhydrin-Kautschuk (ECO), Polyurethan und/oder Epoxid-Polymere erhältlich, und weist einen Füllstoffanteil von mindestens 50 pHr, bevorzugt mindestens 60 pHr auf. In einer weiteren bevorzugten Ausführungsform weist die Polymerschicht einen Anteil an Weichmacher, insbesondere an natürlichen oder synthetischen Weichmachern, von 3 bis 30 pHr, besonders bevorzugt von 5 bis 15 pHr, auf. Als Weichmacher versteht der Fachmann allgemein Substanzen, die freies Volumen in der Polymermatrix erzeugen. Übliche Weichmacher sind paraffinische, naphthenische und/oder aromatische Substanzen, Ester, Ether und Thioether sowie niedermolekulare Substanzen mit mittlere Molmassen unter 1000 g/mol, gemessen mittels Massenspektroskopie, die bei Standardbedingungen (20°C, Normaldruck) flüssig sind, wie Wasser und/oder Polymerlösungen. Mithin weist die Polymerschicht bevorzugt einen Gesamt-Anteil an Weichmacher, ausgewählt aus Paraffinen, Naphthenen, Aromaten, Estern, Ethern, Thioethern und bei Standardbedingungen (20°C, Normaldruck) flüssigen Polymerlösungen mit einer mittleren Molmasse unter 1000 g/mol, gemessen mittels Massenspektroskopie, von 3 bis 30 pHr, besonders bevorzugt von 5 bis 15 pHr, auf.

In einer weiteren Ausführungsform weist die Polymerschicht weniger als 30 pHr, besonders bevorzugt weniger als 15 pHr, insbesondere 0 pHr Weichmacher auf.

In einer bevorzugten Ausführungsform weist die Polymerschicht eine mittlere Dicke, optisch gemessen, von 1 bis 100 mm, bevorzugt von 1 bis 50 mm und besonders bevorzugt von 1 bis 20 mm auf.

Erfindungsgemäß ist es bevorzugt, erst die Substratschicht mit der Haftvermittlerschicht auszustatten und danach die Polymerschicht auf die Haftvermittlerschicht aufzutragen.

Gegenstand der Erfindung ist dabei auch ein Verfahren zur Herstellung eines erfindungsgemäßen Verbundmaterials, umfassend die Schritte:
(a) Bereitstellen der Substratschicht,
(b) Beschichten der Substratschicht mit der Haftvermittlerschicht durch plasmagestützte chemische Gasphasenabscheidung (PE-CVD),
(c) Auftragen einer Polymerverbindung, die beim Vernetzen eine Polymerschicht mit einer Shore-Härte von 60 bis 95 Shore ergeben kann, auf die Haftvermittlerschicht, so dass die Substratschicht zumindest teilweise mit der Polymerverbindung versehen ist,
(d) Vernetzen der Polymerverbindung, so dass eine Polymerschicht mit einer Shore-Härte von 60 bis 95 Shore A erhalten wird und wobei die Haftvermittlerschicht mit der Polymerschicht vorzugsweise kovalent verbunden wird.

Dabei werden die Schritte (a) bis (d) in der angegebenen Reihenfolge ausgeführt.

Bevorzugt erfolgt das Auftragen der Polymerverbindung so, dass die Substratschicht Bereiche aufweist, die mit der Polymerverbindung versehen sind, und andere Bereiche, die nicht mit der Polymerverbindung versehen sind.

Bevorzugt weist die Haftvermittlerschicht, die in Schritt (b) aufgetragen wird, an der Oberfläche ungesättigte Kohlenstoffbindungen auf. Diese reagieren beim Vernetzen der Polymerverbindung in Schritt (d) bevorzugt mit der Polymerverbindung, die bevorzugt ebenfalls reaktive Gruppen aufweist. Dadurch werden die Vorteile einer stabilen Schichtverbindung erreicht, die oben für das erfindungsgemäße Verbundmaterial beschrieben werden.

Ausführungsformen des erfindungsgemäßen Verfahrens umfassen die für das erfindungsgemäße Verbundmaterial vorangehend und nachfolgend beschriebenen Ausführungsformen mutatis mutandis. So ist die Haftvermittlerschicht durch plasmagestützte chemische Gasphasenabscheidung (PE-CVD) erhältlich, bei der zumindest teilweise ein Vorläufermaterial eingesetzt wird, das mindestens eine siliciumorganische Verbindung enthält.

Allgemein kann das Auftragen der Haftvermittlerschicht auf die Substratschicht durch Reaktion im Plasma nach bekannten Verfahren erfolgen. Diesbezüglich wird auf den einleitend erörterten Stand der Technik verwiesen, in dem beispielhaft beschrieben wird, wie Plasma-Schichten aus Kohlenwasserstoffen, siliciumorganischen Verbindungen oder Gemischen von Vorläuferverbindungen erzeugt werden. Allgemein wird das Substrat zunächst gereinigt und in eine geeignete Plasmavorrichtung eingeführt. Bei Bedarf erfolgt in der Vorrichtung zunächst eine nicht-schichtbildende Vorbehandlung in einem Plasmagas, das keine schichtbildenden Vorläuferverbindungen enthält, beispielsweise in Gegenwart von Edelgasen, Sauerstoff oder Stickstoff. Dabei kann das Substrat erneut gereinigt und gegebenenfalls an der Oberfläche aktiviert werden. Anschließend werden geeignete Vorläuferverbindungen zugeführt und die plasmagestützte chemische Gasphasenabscheidung wird durchgeführt. Die Dicke, die Zusammensetzung und das Wachstum der Schicht können durch bekannte Maßnahmen kontrolliert werden, indem beispielsweise und abhängig von der gewählten Verfahrensart die Menge und Konzentration der Vorläuferverbindungen, die Temperatur, die Prozessleistung, der Druck, die Beschichtungsdauer, die Verfahrgeschwindigkeit der Plasmadüse, der Abstand zwischen Düse und Substratschicht, die Zuführung von Inertgas und sonstige Parameter variiert werden. Nach Ausbildung der gewünschten Beschichtung wird der PE-CVD-Prozess gestoppt, indem beispielsweise das Substrat aus der Vorrichtung entfernt wird; oder indem der Leistungseintrag oder der Zufluss von Vorläuferverbindungen unterbrochen wird. Entsprechende Verfahren und Modifikationen sind bekannt und in der Literatur hinlänglich beschrieben. Lediglich beispielhaft wird dazu auf das Lehrbuch "Advanced Plasma Technology", d'Agostino et al. (Editor), Verlag Wiley-VCH, 2008, verwiesen.

Das Aufbringen der Polymerschicht kann nach üblichen Verfahren erfolgen. Dabei ist es bevorzugt, dass eine Polymerverbindung nicht in fester Form, und dabei insbesondere in flüssiger, pastöser oder hochviskoser Form aufgebracht und anschließend zu der Polymerschicht verfestigt wird. Dabei wird die Polymerverbindung insbesondere als Schmelze oder Gemisch mit einem Lösungsmittel aufgetragen. Erfindungsgemäß bevorzugt erfolgt der Auftrag einer Polymerschicht auf die Haftvermittlerschicht derart, dass die Substratschicht Bereiche aufweist, die mit der Polymerverbindung versehen sind, und andere Bereiche, die nicht mit der Polymerverbindung versehen sind.

Das Verfestigen der Polymerverbindung erfolgt dabei bevorzugt durch Vulkanisieren und/oder Vernetzen. Das Aufbringen der flüssigen, pastösen oder hochviskosen Polymerverbindung kann nach üblichen Formgebungsverfahren erfolgen, beispielsweise durch Spritzgießen (Injection Molding), Pressverfahren (Compression molding) oder Transferverfahren (Transfer moulding). Dabei wird eine Formmasse in eine Kammer auf das beschichtete Substrat gebracht, in der sie unter Wärme und Druck vernetzt. Das Verfahren ist insbesondere zur Herstellung von Elastomerbauteilen, wie etwa Dichtungen, geeignet. Bei der Vernetzung unter Wärme und Druck kann parallel die Ausbildung von kovalenten Bindungen der Polymerschicht zu der Haftvermittlerschicht erfolgen.

In einer bevorzugten Ausführungsform können die Polymerschicht und/oder die Polymerverbindung Additive enthalten. Insbesondere sind Additive bevorzugt, die das Aushärten fördern, wie Vernetzungshilfsstoffe und Katalysatoren zur Vulkanisation. Als Vernetzungshilfsstoffe können insbesondere Schwefel, Peroxide, Metallverbindungen insbesondere Metalloxide, Silane, Amine, Bisphenole, oder Phenolharze enthalten sein. Die Polymerschicht kann auch übliche Additive enthalten, welche die Eigenschaften in gewünschter Weise modifizieren, wie Füllstoffe, Weichmacher, Verarbeitungshilfsmittel, Bindehilfsmittel, Lichtschutzmittel oder Farbstoffe.

Gegenstand der Erfindung ist auch die Verwendung einer Haftvermittlerschicht zum Verbinden einer Substratschicht mit einer Polymerschicht, wobei Polymerschicht und Substratschicht durch die Haftvermittlerschicht miteinander verbunden sind, und wobei die Haftvermittlerschicht durch plasmagestützte chemische Gasphasenabscheidung (PE-CVD) erhältlich ist, bei der zumindest teilweise eine Vorläuferverbindung eingesetzt wird, die mindestens eine siliciumorganische Verbindung enthält, und wobei die Polymerschicht eine Shore-Härte, gemessen nach DIN ISO 7619-1: 2021-02, Shore A, 23 °C, von 60 bis 95 Shore A aufweist. Die Verwendung erfolgt dabei insbesondere mit den erfindungsgemäßen Verbundmaterialien. Ausführungsformen der erfindungsgemäßen Verwendung umfassen die für das erfindungsgemäße Verbundmaterial vorangehend und nachfolgend beschriebenen Ausführungsformen mutatis mutandis. So weist die Substratschicht beispielsweise bevorzugt Bereiche auf, die unmittelbar durch die Haftvermittlerschicht mit der Polymerschicht verbunden sind, und andere Bereiche, die nicht mit der Polymerschicht verbunden sind.

Die erfindungsgemäßen Verbundmaterialien zeichnen sich durch eine hohe Stabilität aus. Die Substratschicht kann nur durch starke mechanische Kräfte von der Polymerschicht gelöst werden. Daher können die Verbundmaterialien für Anwendungen eingesetzt werden, bei denen starke mechanische Kräfte auf die Materialien wirken. Alternativ können Anwendungen im Kontakt mit materialbeanspruchenden und/oder aggressiven flüssigen oder gasförmigen Medien von Vorteil sein.

Die Verbundmaterialien sind bevorzugt durch eine hohe Haftkraft oder Haftfestigkeit der Polymerschicht und der Substratschicht charakterisiert. Somit sind bevorzugt hohe Trennkräfte erforderlich, um die Polymerschicht von der Substratschicht abzulösen. Die Haftfestigkeit von Schichtmaterialien wird bevorzugt gemäß der ASTM D429: 2014-01 ermittelt. Die Haftfestigkeit von Polymerschichten wird dabei bevorzugt im 90° Schälversuch in Anlehnung an Methode B ermittelt. Abweichend zur Norm wird mit einer Prüfgeschwindigkeit von 100 mm/ min geprüft. Ebenfalls unterscheiden sich die Prüfkörper leicht, da die Gummiauflage kleiner 6 mm ist und ein Schälweg bzw. eine Prüflänge am Schälstreifen von mindestens 30 mm betrachtet wird.

Bevorzugt zeigt sich bei den erfindungsgemäßen Verbundmaterialien ein Versagensbild im Elastomermaterial, also in der Polymerschicht (Versagensbild R gemäß den Ausführungsbeispielen), und nicht eine Ablösung der Schichten voneinander.

Gegenstand der Erfindung ist auch die Verwendung des erfindungsgemäßen Verbundmaterials als Dichtungsartikel oder zur Herstellung eines Dichtungsartikels. Ein bevorzugter Gegenstand der Erfindung ist ein Dichtungsartikel, enthaltend ein Verbundmaterial gemäß einer oder mehrerer der vorangehend oder nachfolgend beschriebenen Ausführungsformen.

Die erfindungsgemäßen Verbundmaterialien eignen sich wegen der hohen Stabilität in besonderem Maße als Dichtungsartikel. Ein Dichtungsartikel ist ein Element, das die Aufgabe habt, ungewollte Stoffübergänge von einem Ort zu einem anderen zu verhindern oder zu begrenzen.

Gegenstand der Erfindung ist auch ein Dichtungsartikel, enthaltend ein erfindungsgemäßes Verbundmaterial. Ein bevorzugter Dichtungsartikel ist eine Flanschdichtung, Steckverbindung (z.B. Plug & Seal), ein Metall-O-Ring, eine Ventil-, Flüssigdichtung oder integrierte statische Dichtung auf metallischem oder polymerem Bauteil (zum Beispiel Elastomerdichtung auf metallischen Bipolarplatten für Brennstoffzellenanwendungen), eine Gleitringdichtung, ein Radialwellendichtring, eine Labyrinthwellendichtung, eine Flachdichtung, ein Kolbenring, ein Magnetanker, einem Faltenbalg oder einer Membrandichtung.

Eine bevorzugte Verwendung ist die Verwendung als dynamischer Dichtungsartikel, bevorzugt als eine Gleitringdichtung, ein Radialwellendichtring, eine Labyrinthwellendichtung, eine Flachdichtung, ein Kolbenring oder eine Spezialdichtung, wie ein Magnetanker, Faltenbalg oder Membran. Dynamische Dichtungsartikel dienen zur Abdichtung bewegter Maschinenteile, die eine gemeinsame, bewegte Grenzfläche aufweisen. Ein dynamischer Dichtungsartikel ist durch eine beträchtliche Bewegung dieser Grenzfläche charakterisiert, die bei statischen Dichtungsartikeln fehlt. Vor allem bei dynamischen Dichtungsartikeln müssen Dichtungsmaterialien bei hohen mechanischen Belastungen über lange Zeiträume eine gleichbleibende Dichtwirkung erbringen. Bevorzugt ist der Dichtungsartikel ein dynamischer Dichtungsartikel, insbesondere eine Gleitringdichtung, ein Radialwellendichtring, eine Labyrinthwellendichtung, eine Flachdichtung, ein Kolbenring oder eine Spezialdichtung, wie ein Magnetanker, Faltenbalg oder Membran.

Eine besonders bevorzugte Verwendung ist die Verwendung des Verbundmaterials als statischer Dichtungsartikel, bevorzugt als Flanschdichtungen, Steckverbindungen (z.B. Plug & Seal), Metall-O-Ringe, Ventile, Flüssigdichtungen oder integrierte statische Dichtungen auf metallischem oder polymerem Bauteil (zum Beispiel Elastomerdichtungen auf metallischen Bipolarplatten für Brennstoffzellenanwendungen). Bevorzugt ist der Dichtungsartikel ein statischer Dichtungsartikel, insbesondere Flanschdichtungen, Steckverbindungen (z.B. Plug & Seal), Metall-O-Ringe, Ventile, Flüssigdichtungen oder integrierte statische Dichtungen auf metallischem oder polymerem Bauteil (zum Beispiel Elastomerdichtungen auf metallischen Bipolarplatten für Brennstoffzellenanwendungen).

Die erfindungsgemäßen Verbundmaterialien, Verfahren und Verwendungen lösen die Aufgabe, die der Erfindung zugrunde liegt. Es werden Verbundmaterialien bereitgestellt, bei denen eine Vielzahl verschiedener Substrate mit verschiedenen weiteren Materialien stabil und dauerhaft verbunden werden kann. Insbesondere ermöglicht die Erfindung eine stabile Verbindung von Metallen mit Polymeren oder von verschiedenen Polymeren miteinander. Die Verbundmaterialien bestehen aus üblichen Komponenten. Sie sind durch relativ einfache Verfahren in wenigen Schritten erhältlich. Die Haftvermittlerschichten auf Basis von siliciumorganischen Verbindungen haften gut auf einer Vielzahl von verschiedenen Substraten und ermöglichen eine stabile Verbindung mit einer Vielzahl weiterer, unterschiedlicher Materialien.

### Ausführungsbeispiele

### Herstellung der Beschichtung

Verschiedene Grundkörper werden in einem plasma-unterstützten Prozess der chemischen Gasphasenabscheidung mit einer Beschichtung versehen. Dazu stehen zwei Verfahrensabläufe zur Verfügung:
In Variante 1 wird eine Niederdruck-Plasma-Anlage für eine asymmetrische, kapazitiv gekoppelte Radiofrequenz-Entladung verwendet. Die Grundkörper (Substrate) werden mit Kontakt auf der Elektrode positioniert. Bei diesem Prozess wird ein Vorläufermaterial, das eine siliciumorganische Verbindung und gegebenenfalls als Kohlenstoffquelle Acetylen oder Ethylen enthält, verwendet. Der Zusatz von weiteren Reaktiv- Gasen, bspw. Sauerstoff, Argon, Stickstoff, ist ebenfalls möglich. Durch Anregung mit elektromagnetischer Strahlung, beispielsweise bei Radiofrequenz, werden diese Gase bei Prozessdrücken von wenigen Pascal in den Plasmazustand versetzt. Die Moleküle werden gespalten und kondensieren als PE-CVD Schicht auf der Oberfläche des Grundkörpers. Zur besseren Anbindung der Schicht an die Grundkörper werden diese zunächst in einem nicht-schichtbildenden Plasma, bspw. aus Argon und/oder Sauerstoff, aktiviert. Hierbei können je nach Beschaffenheit der Grundkörperoberfläche Fragmente von der Oberfläche in die Plasmaphase übergehen und in die Beschichtung mit eingebaut werden. Prinzipiell ist es bei dieser Verfahrensvariante möglich und auch gängige Praxis, mehrere Prozessabschnitte zu einem Gesamtprozess zu vereinen. So können z.B. die Prozessgaszusammensetzungen und/ oder die Zusammensetzung des Vorläufermaterials im Laufe des Prozesses variiert werden und die lokale Schichtzusammensetzung graduell oder stufenartig beeinflusst werden.

Die zweite Verfahrensvariante (im Folgenden Variante 2) wird mit Atmosphärendruck-Plasma-Anlagen durchgeführt. Hierbei wird das Plasma aus einem nicht-schichtbildendem Gas (bspw. Luft oder Stickstoff) bei Atmosphärendruck in einer Düse gezündet und durch Gasströmung auf das zu beschichtende Substrat geleitet. Im Düsenausgang wird diesem bisher nicht-schichtbildenden Plasma noch das Vorläufermaterial in Gasform, Dampfform oder als Aerosol beigemischt, im Plasma aktiviert und dann als Beschichtung auf dem Substrat abgeschieden. Zur vollflächigen Beschichtung einer Oberfläche bewegt sich die Düse parallel zur Substratoberfläche in definiertem Abstand dazu über die Oberfläche. Bei Variante 2a wird das Plasma in der Düse mit einer Bogenentladung (Arc) erzeugt. Bei Variante 2b wird das Plasma in einer dielektrisch-behinderten Barriere-Entladung (DBD) erzeugt.

Wenn nicht weiter spezifiziert werden in den folgenden Ausführungsbeispielen Substrate aus Edelstahl (polierte, entfettete Edelstahl-Streifen Typ 1.4301 mit den Abmessungen Breite x Länge 20 mm x 100 mm) verwendet.

### Beispiele

### Beispiel 1: Metall-Elastomer-Verbunde

PE-CVD-Schicht A wird im Niederdruck-Plasmaverfahren (Variante 1) auf Edelstahl-Grundkörpern abgeschieden. Der Prozess zur Abscheidung von PE-CVD-Schicht A besteht zunächst aus einem Aktivierungsschritt in nicht-schichtbildendem Plasma (Prozessgasfluss: 70 sccm Ar, Bias-Spannung: 400 V), das dann in ein schichtbildendes Plasma aus einer siliciumorganisch angereicherten Basis (Prozessgasfluss: 30 sccm HMDSO (CAS-Nr.: 107-46-0); Bias-Spannung: 400 V) und anschließend einen kohlenstoff-reicheren und silicium-ärmeren Abschluss (Prozessgasfluss: 60 sccm Acetylen (CAS-Nr.: 74-86-2), 4 sccm HMDSO, Prozessleistung: 400 W) graduell übergeht.

PE-CVD-Schicht B wird ebenfalls im Niederdruck-Plasmaverfahren auf Edelstahl-Grundkörpern abgeschieden. Der Prozess besteht zunächst aus einem Aktivierungsschritt in nicht-schichtbildendem Plasma (Prozessgasfluss: 70 sccm Ar, Bias-Spannung: 400 V), das dann in ein schichtbildendes Plasma aus einer siliciumorganisch angereicherten Basis (Prozessgasfluss: 30 sccm HMDSO; Bias-Spannung: 400 V) und anschließend einen kohlenstoff-reicheren Abschluss (Prozessgasfluss: 60 sccm Ethen (CAS-Nr.: 74-85-1), Prozessleistung: 400 W) graduell übergeht.

Nach Applikation der Schichtsysteme auf den Grundkörpern werden sie in einem Compression-Molding-Prozess (CM-Prozess) mit einer Lage Elastomer versehen. Dazu wird die unvulkanisierte Elastomer-Mischung auf die Metallstreifen aufgelegt und unter Druck und bei Temperatur an den beschichteten Grundkörper anvulkanisiert (Prozessbedingungen: T = 180 °C, p = 230 bar, t = 10 min).

Die Shore-Härte der Elastomermischungen erfolgt basierend auf 6 mm Platten und wird nach DIN ISO 7619-1:2021-02 (Shore A, 23 °C) ermittelt.

### Folgende Elastomer-Mischungsvarianten, basierend auf dem Grundpolymer EPDM werden verwendet:

**Tabelle 1: Übersicht der verwendeten Mischungszusammensetzungen (alle Angaben in pHr)**

| Inhaltsstoff | Kategorie | Mischung 1 | Mischung 2 (Vergleic hsmischu ng) | Mischung 3 | Mischung 4 |
|---|---|---|---|---|---|
| Keltan^{®} 2450 | Kautschuk | 100 | 100 | 100 | 100 |
| N 772 | Füllstoff | 60 | 30 | 80 | 100 |
| Tudalen^{®} D18 | Weichmacher | 0 | 0 | 10 | 25 |
| Perkadox^{®} BC- 40 | Vernetzung | 8 | 8 | 8 | 8 |
| Zinc oxide | Aktivator | 3 | 3 | 3 | 3 |
| TMQ | Aktivator | 2 | 2 | 2 | 2 |
| Stearic acid | Aktivator, Dispergator | 1 | 1 | 1 | 1 |
| Härte der Elastomermisch ung in Shore A | | 66 | 59 | 63 | 61 |

Nach dem Vulkanisationsprozess werden aus der erkalteten Elastomer-Metall-Verbunden Prüfkörper ausgestanzt und geschliffen. Für die Schälprüfung entsteht ein Probekörper bestehend aus einem starren, metallischen Grundkörper, einer Plasma-Haftvermittlerschicht und einer darauf aufvulkanisierten Elastomerauflage. Zur Bewertung des Verbundes wird eine 90°-Schälprüfung in Anlehnung an ASTM D429: 2014-01 gemäß Methode B durchgeführt. Abweichend zur Norm wird mit einer Prüfgeschwindigkeit von 100 mm/ min geprüft. Ebenfalls unterscheiden sich die Prüfkörper leicht von den Vorgaben der Norm, da die Gummiauflage kleiner 6 mm dick ist und ein Schälweg bzw. eine Prüflänge am Schälstreifen von mehr als 30 mm betrachtet wird.

Als wichtigstes Bewertungskriterien der Haftvermittlung wird das Versagensbild herangezogen. R bezeichnet hierbei ein Versagen im Elastomer, RC das Versagen zwischen Elastomer und Haftvermittler, MC zwischen Metall und Haftvermittler sowie MR zwischen Metall und Elastomer. Ergänzend zum Versagensbild R wird durch die Angabe einer Zahl die Elastomerauflage auf der Haftvermittlerschicht in Prozent, d.h. 100 R bezeichnet eine verbleibende Elastomerauflage von 100 %, angegeben.

**Tabelle 2: Shore-Härte der EPDM-Mischungen und Ergebnisse der Haftungsprüfung mit PE-CVD-beschichteten Edelstahlstreifen**

| | Mischung 1 | Mischung 2 (Vergleichsmischung) | Mischung 3 | Mischung 4 |
|---|---|---|---|---|
| Härte der Elastomermischung in Shore A | 66 | 59 | 63 | 61 |
| Versagensbild in der Schälprüfung (PE-CVD-Schicht A auf Edelstahl) | 100 R | 0 R | 95 R | 100 R |
| Versagensbild in der Schälprüfung (PE-CVD-Schicht B auf Edelstahl) | 100 R | 0 R | 100 R | 100 R |
| | | | | |

Es zeigt sich, dass mit Elastomermischungen mit einer Shore-Härte im erfindungsgemäßen Bereich (Mischung 1, 3 und 4) in Kombination mit den PE-CVD-Schichten A und B deutlich bessere Versagensbilder und somit Haftungsergebnisse erzielt werden. Dies ist insbesondere für die Elastomermischungen 3 und 4 überraschend, da hohe Weichmacherzugaben in der Regel eher nachteilig für die Ausbildung von stabilen Metall-Elastomer-Verbunden sind.

### Beispiel 2: Gummi-Thermoplast-Verbunde

Die Beschichtungsprozesse zu PE-CVD-Schicht A und PE-CVD-Schicht B werden analog zu Beispiel 1 durchgeführt. Anstelle der Edelstahl-Grundkörper werden aber nun Grundkörper aus PA 66 mit 30 % Glasfasern (PA66 GF) mit den Abmessungen 25 mm x 100 mm (Breite x Länge) beschichtet. Die Herstellung der Prüfkörper erfolgt ebenfalls analog Beispiel 1.

**Tabelle 3: Ergebnisse der Haftungsprüfung mit PE-CVD-beschichteten PA66-Streifen mit verschiedenen EPDM-Mischungen**

| | Mischung 1 | Mischung 2 (Vergleichsmischung) | Mischung 3 | Mischung 4 |
|---|---|---|---|---|
| Härte der Elastomermischung in Shore A | 66 | 59 | 63 | 61 |
| Versagensbild in der Schälprüfung (PE-CVD-Schicht A auf PA66 GF) | 100 R | 0 R | 100 R | 95 R |
| Versagensbild in der Schälprüfung (PE-CVD-Schicht B auf PA66 GF) | 100 R | 0 R | 100 R | 75 R |
| | | | | |

Es zeigt sich, dass mit Elastomermischungen mit einer Shore-Härte im erfindungsgemäßen Bereich (Mischung 1, 3 und 4) in Kombination mit den PE-CVD-Schichten A und B deutlich bessere Versagensbilder und somit Haftungsergebnisse erzielt werden.

### Beispiel 3: Chemische Zusammensetzung

Die PE-CVD-Schicht A und B werden im Verfahren 1 auf Edelstahl und PA66 GF abgeschieden und mittels Röntgen-Photoelektronen-Spektroskopie (XPS) untersucht. Diese Methode analysiert die obersten Nanometer (bis zu 10 nm), die unmittelbar mit der zu bindenden Phase in Kontakt steht.

**Tabelle 4: Chemische Zusammensetzung der Haftvermittleroberflächen**

| PE-CVD-Schicht | Anteil Si [at%] | Anteil C [at%] | Anteil O [at%] | Anteil sonstige [at%] |
|---|---|---|---|---|
| A (auf Edelstahl) | 3 | 87 | 10 | |
| A (auf PA66GF) | 3 | 85 | 12 | |
| B (auf Edelstahl) | | 93 | 7 | |
| B (auf PA66GF) | | 91 | 9 | |

### Beispiel 4: Gummi-Metall-Verbunde

PE-CVD-Schicht C wird im Niederdruck-Plasmaverfahren (Variante 1) auf Edelstahl-Grundkörpern abgeschieden. Der Prozess zur Abscheidung von Schichtsystem C besteht zunächst aus einem Aktivierungsschritt in nicht-schichtbildendem Plasma (Prozessgasfluss: 70 sccm Ar, Bias-Spannung: 400 V), das dann in ein schichtbildendes Plasma aus einer siliciumorganisch angereicherten Basis (Prozessgasfluss: 30 sccm HMDSO; Bias-Spannung: 400 V) und anschließend einen kohlenstoffreicheren mit siliciumorganischem Abschluss (Prozessgasfluss: 60 sccm Acetylen, 30 sccm HMDSO, Prozessleistung: 400 W) graduell übergeht.

Die Grundkörper werden analog zu den vorherigen Beispielen zu Schälprüfkörpern weiterverarbeitet. Dabei kommen die Mischung 5 mit dem Grundpolymer FKM und Mischung 6 mit dem Grundpolymer AEM als Bindepartner zum Einsatz (Zusammensetzung siehe Tabelle 5 und 6). Die Prüfkörper mit Mischung 5 werden zunächst bei 180 °C für 10 min vulkanisiert und anschließend bei 200 °C für 24 h nachgeheizt. Die Prüfkörper mit Mischung 6 werden ebenfalls bei 180 °C für 10 min vulkanisiert und anschließend bei 175 °C für 5 h nachgeheizt. Die Schälprüfung wird analog zu Beispiel 1 durchgeführt.

**Tabelle 5: Übersicht der verwendeten Mischungszusammensetzungen für Mischung 5 (alle Angaben in pHr)**

| Inhaltsstoff | Kategorie | Mischung 5 |
|---|---|---|
| Tecnoflon^{®} T 636 | Kautschuk | 100 |
| N 772 | Füllstoff | 30 |
| Calcium hydroxide | Aktivator, Säurefän ger | 6 |
| Magnesium oxide | Aktivator, Säurefän ger, Hitzestabilisator | 3 |
| Tecnoflon^{®} FOR M 1 | Vernetzung | 4 |
| Tecnoflon^{®} FOR M 2 | Beschleuniger | 1,5 |

**Tabelle 6: Übersicht der verwendeten Mischungszusammensetzungen für Mischung 6 (alle Angaben in pHr)**

| Inhaltsstoff | Kategorie | Mischung 6 |
|---|---|---|
| Vamac^{®} Ultra IP | Polymer | 100 |
| N 550 | Füllstoff | 65 |
| Rhenosin^{®} W 759 | Weichmacher | 10 |
| Stearic acid | Aktivator, Dispergator | 1,5 |
| | | |
| CDPA | Alterungsschutz | 2 |
| Vanfre^{®} VAM | Verarbeitungshilfsmittel | 1 |
| Armeen^{®} 180 | Verarbeitungshilfsmittel | 0,5 |
| HMDC | Vernetzung | 1,5 |
| Rhenogran^{®} XLA-60 | Aktivator, Beschleuniger | 2 |

**Tabelle 7: Ergebnisse der Haftungsprüfung mit plasma-beschichteten Edelstahl-Streifen mit verschiedenen Elastomer-Mischungen**

| | Mischung 5 | Mischung 6 |
|---|---|---|
| Härte der Elastomermischung in Shore A | 71 | 67 |
| Versagensbild in der Schälprüfung (PE-CVD-Schicht C auf Edelstahl) | 100 R | 90 R |

### Beispiel 5: Gummi-Metall-Verbunde

PE-CVD-Schicht D wird im Atmosphärendruck-Plasma-Verfahren, Variante 2b abgeschieden. Als Plasmagas wird Stickstoff (80 slm) verwendet, als Trägergas Stickstoff (5 slm). Als Vorläufermaterial wird MEMO (CAS-Nr. 2530-85-0) eingesetzt mit einem Fluss von 1 slm dem Trägergas beigemischt und dem Plasmagas zugeführt. Das Plasma wird mit einer Spannung von 450 W gezündet.

Die Düse bewegt sich zur Beschichtung in einem Abstand von 1 mm und einer Geschwindigkeit von 50 mm/s über den zu beschichteten Edelstahl-Grundkörper. Es werden drei Beschichtungsdurchläufe durchgeführt

Die Prüfkörper werden mit Mischung 7, basierend auf dem Polymer FKM, hergestellt (Zusammensetzung siehe Tabelle 8). Die Vulkanisation von Mischung und Prüfkörper erfolgt bei 180 °C für 10 min. Die Prüfkörper werden weiterhin bei 230 °C für 22 h nachgeheizt.

Die Schälprüfkörper versagen im Elastomer, das Versagensbild ist 100 R.

**Tabelle 8: Übersicht der verwendeten Mischungszusammensetzung für Mischung 7 (alle Angaben in pHr)**

| Inhaltsstoff | Kategorie | Mischung 7 |
|---|---|---|
| Tecnoflon^{®} P 757 | Kautschuk | 100 |
| N 990 | Füllstoff | 30 |
| Zinc oxide | Aktivator | 5 |
| TAIC 70% | Coagenz | 4 |
| Luperox^{®} 101 XL 45 | Vernetzung | 3 |
| | | |

### Vergleichsbeispiel 6: Gummi-Metall-Verbunde

PE-CVD-Schicht E wird im Atmosphärendruck-Plasma-Verfahren, Variante 2b abgeschieden. Als Plasmagas wird Stickstoff (80 slm) verwendet, als Trägergas Stickstoff (5 slm). Als Vorläufermaterial wird Ethylenglycolmethacrylat (CAS-Nr. 97-90-5) eingesetzt mit einem Fluss von 1 slm dem Trägergas beigemischt und dem Plasmagas zugeführt. Das Plasma wird mit einer Spannung von 450 W gezündet. Die Düse bewegt sich zur Beschichtung in einem Abstand von 1 mm und einer Geschwindigkeit von 50 mm/s über den zu beschichteten Edelstahl-Grundkörper. Es werden drei Beschichtungsdurchläufe durchgeführt.

Prüfkörper werden mit Mischung 1 und Mischung 7 hergestellt. Dabei konnte keine Verbindung zwischen Grundkörper und Mischung erlangt werden, alle Prüfkörper versagen mit dem Versagensbild 0 R bzw. RC. Hieraus zeigt sich, dass die Verwendung siliciumorganische Vorläuferverbindungen für die PE-CVD-Haftvermittlerschicht die Herstellung von stabilen Elastomer-Metall-Verbunden fördert.

### Beispiel 7: Gummi-Metall-Verbunde

PE-CVD-Schicht F wird im Atmosphärendruck-Plasma-Verfahren, Variante 2b abgeschieden. Als Plasmagas wird Stickstoff (80 slm) verwendet, als Trägergas Stickstoff (5 slm). Als Vorläufermaterial wird MTMO (CAS-Nr. 4420-74-0) eingesetzt mit einem Fluss von 1 slm dem Trägergas beigemischt und dem Plasmagas zugeführt. Das Plasma wird mit einer Spannung von 450 W gezündet. Die Düse bewegt sich zur Beschichtung in einem Abstand von 1 mm und einer Geschwindigkeit von 50 mm/s über den zu beschichteten Edelstahl-Grundkörper. Es werden drei Beschichtungsdurchläufe durchgeführt
Die Prüfkörper werden mit Mischung 5 und 7 hergestellt.

Die Schälprüfkörper versagen im Elastomer, das Versagensbild ist 100 R.

### Beispiel 8: Gummi-Metall-Verbunde

PE-CVD-Schicht G wird im Atmosphärendruck-Plasma-Verfahren, Variante 2a abgeschieden. Als Plasmagas wird Luft (30 l/min) verwendet, als Trägergas Stickstoff (8 l/min). Als Vorläufermaterial wird MEMO eingesetzt, auf 200 °C erhitzt und mit einem Fluss von 8 g/h dem Trägergas beigemischt und dem Plasmagas zugeführt. Das Plasma wird mit einer Spannung von 250 V, einer Frequenz von 21 kHz und Power to Cycle Time von 100% gezündet. Die Düse bewegt sich zur Beschichtung in einem Abstand von 10 mm und einer Geschwindigkeit von 15 m/min über den zu beschichteten Edelstahl-Grundkörper.

Im Anschluss werden Prüfkörper für Schälprüfungen wie in Beispiel 1 hergestellt. Zusätzlich zu Mischung 5 und 6 wird hier auch die Haftung zu Mischung 8 mit dem Grundpolymer HNBR untersucht. Mischung 8 wird bei 180 °C für 10 min vulkanisiert.

**Tabelle 9: Übersicht der verwendeten Mischungszusammensetzung für Mischung 8 (alle Angaben in pHr)**

| Inhaltsstoff | Kategorie | Mischung 8 |
|---|---|---|
| Zetpol^{®} 2010 | Kautschuk | 100 |
| N 772 | Füllstoff | 50 |
| Zinc oxide | Aktivator | 3 |
| Magnesium oxide | Aktivator, Säurefänger, Hitzestabilisator | 3 |
| Deogum^{®} 80 | Verarbeitungshilfsmittel | 2 |
| TRIM 70% | Coagenz | 5 |
| Peroxan^{®} BIB-40 | Vernetzung | 7 |

**Tabelle 10: Ergebnisse der Haftungsprüfung mit plasma-beschichteten Edelstahl-Streifen mit verschiedenen Elastomer-Mischungen**

| | Mischung 5 | Mischung 6 | Mischung 8 |
|---|---|---|---|
| Härte der Elastomermischung in Shore A | 71 | 67 | 71 |
| Versagensbild in der Schälprüfung (PE-DVD-Schicht G auf Edelstahl) | 80 R | 90 R | 100 R |

### Beispiel 9: Gummi-Metall-Verbunde

PE-DVD-Schicht H wird im Atmosphärendruck-Plasma-Verfahren, Variante 2a abgeschieden. Als Plasmagas wird Luft (30 l/min) verwendet, als Trägergas Stickstoff (8 l/min). Als Vorläufermaterial wird MTMO eingesetzt, auf 200 °C erhitzt und mit einem Fluss von 10 g/h dem Trägergas beigemischt und dem Plasmagas zugeführt. Das Plasma wird mit einer Spannung von 250 V, einer Frequenz von 21 kHz und Power to Cycle Time von 100% gezündet. Die Düse bewegt sich zur Beschichtung in einem Abstand von 10 mm und einer Geschwindigkeit von 15 m/min über den zu beschichteten Grundkörper. Beschichtet werden nun Grundkörper aus PA 66 mit 30 % Glasfasern (PA66 GF) mit den Abmessungen 25 mm x 100 mm (Breite x Länge). Die Prüfkörper werden mit Mischung 7, basierend auf dem Polymer FKM, hergestellt.

Die Schälprüfkörper versagen im Elastomer, das Versagensbild ist 100 R.

### Beispiel 10: Gummi-Metall-Verbunde

PE-DVD-Schicht I wird im Atmosphärendruck-Plasma-Verfahren, Variante 2a abgeschieden. Als Plasmagas wird Luft (30 l/min) verwendet, als Trägergas Stickstoff (8 l/min). Als Vorläufermaterial wird GLYMO (CAS-Nr. 2530-83-8) eingesetzt, auf 180 °C erhitzt und mit einem Fluss von 5 g/h dem Trägergas beigemischt und dem Plasmagas zugeführt. Das Plasma wird mit einer Spannung von 250 V, einer Frequenz von 21 kHz und Power to Cycle Time von 35% gezündet. Die Düse bewegt sich zur Beschichtung in einem Abstand von 15 mm und einer Geschwindigkeit von 10 m/min über den zu beschichteten Grundkörper.

Beschichtet werden Grundkörper aus dem anfangs genannten Edelstahl. Die Prüfkörper werden mit Mischung 5 hergestellt.

Die Schälprüfkörper versagen im Elastomer, das Versagensbild ist 100 R.

### Beispiel 11: Gummi-Metall-Verbunde

PE-DVD-Schicht J wird im Atmosphärendruck-Plasma-Verfahren, Variante 2a abgeschieden. Als Plasmagas wird Luft (30 l/min) verwendet, als Trägergas ebenfalls Luft (8 l/min). Als Vorläufermaterial wird VEOS (CAS-Nr. 78-08-0) eingesetzt, auf 100 °C erhitzt und mit einem Fluss von 15 g/h dem Trägergas beigemischt und dem Plasmagas zugeführt. Das Plasma wird mit einer Spannung von 280 V, einer Frequenz von 23 kHz und Power to Cycle Time von 40% gezündet. Die Düse bewegt sich zur Beschichtung in einem Abstand von 20 mm und einer Geschwindigkeit von 20 m/min über den zu beschichteten Grundkörper. Der Versatz der Spuren beträgt dabei 4 mm. Beschichtet werden nun Grundkörper aus PA 66 mit 30 % Glasfasern (PA66 GF) mit den Abmessungen 25 mm x 100 mm (Breite x Länge). Die Prüfkörper werden mit Mischung 7 hergestellt.

Die Schälprüfkörper versagen im Elastomer, das Versagensbild ist 100 R.

### Beispiel 12: Chemische Zusammensetzung

Die PE-CVD-Schichten G und H werden im Verfahren 2a auf PA66 GF und zusätzlich auf Edelstahl abgeschieden und mittels Röntgen-Photoelektronen-Spektroskopie (XPS) untersucht.

**Tabelle 11: Chemische Zusammensetzung der Haftvermittleroberflächen**

| Haftschicht | Anteil Si [at%] | Anteil C [at%] | Anteil O [at%] | Anteil sonstige [at%] |
|---|---|---|---|---|
| G (auf Edelstahl) | 12 | 45 | 43 | |
| G (auf PA66GF) | 13 | 47 | 37 | 3 |
| H (auf Edelstahl) | 15 | 41 | 39 | 4 (Schwefel) |
| H (auf PA66GF) | 16 | 38 | 43 | 4 (Schwefel) |

## Patentansprüche

1. Verbundmaterial, das eine Substratschicht und eine Polymerschicht aufweist, wobei Polymerschicht und Substratschicht unmittelbar durch eine Haftvermittlerschicht miteinander verbunden sind, und wobei die Haftvermittlerschicht durch plasmagestützte chemische Gasphasenabscheidung (PE-CVD) erhältlich ist, bei der zumindest teilweise ein Vorläufermaterial eingesetzt wird, das mindestens eine siliciumorganische Verbindung enthält, **dadurch gekennzeichnet, dass** die Polymerschicht eine Shore-Härte, gemessen nach DIN ISO 7619-1: 2021-02, Shore A, 23 °C, von 60 bis 95 Shore A aufweist.

2. Verbundmaterial gemäß Anspruch 1, wobei die Substratschicht Bereiche aufweist, die unmittelbar durch die Haftvermittlerschicht mit der Polymerschicht verbunden sind, und andere Bereiche, die nicht mit der Polymerschicht verbunden sind.

3. Verbundmaterial gemäß Anspruch 1 oder 2, wobei die Substratschicht eine Metallschicht ist, wobei die Metallschicht mindestens ein Metall ausgewählt aus der Gruppe bestehend aus Eisen, Eisenlegierungen, insbesondere Stahl, Aluminium, Aluminiumlegierungen, Kupfer, Kupferlegierungen, insbesondere Messing, Nickel, Nickellegierungen, Titan, Titanlegierung und Gemischen hiervon aufweist.

4. Verbundmaterial gemäß Anspruch 1 oder 2, wobei die Substratschicht eine Kunststoffschicht ist, wobei die Kunststoffschicht mindestens einen Thermoplast ausgewählt aus der Gruppe bestehend aus Polyamid, Polyphenylensulfid, Polyester und Gemische hiervon, enthält.

5. Verbundmaterial gemäß mindestens einem der vorhergehenden Ansprüche, wobei die siliciumorganische Verbindung ein Silan, ein Organosilan, ein Siloxan, ein Alkoxysilan und/oder Gemische hiervon ist.

6. Verbundmaterial gemäß mindestens einem der vorhergehenden Ansprüche, wobei die siliciumorganische Verbindung ein Silan, ein Organosilan, eine Verbindung der allgemeinen Formel (I)
Y-[O-Si(-X-Z)ₚ(OY)ₘ]ₙ-O-Y
oder eine vernetzte Form davon, oder eine cyclische Form davon, worin
für jedes betreffende Si-Atom m gleich 0 bis 2 ist, und p gleich 2-m ist,
Z ausgewählt ist unter
Amino-, vorzugsweise primärem Amino- (-NH₂), sekundärem Amino-, insbesondere (-NHCH₃), tertiärem Amino-, insbesondere (-N(CH₃)₂), (-N(CH₂CH₃)₂);
C₁-C₁₄-Carboxyl- (d.h. -C(=O)OR¹ mit R¹ = C¹- bis C¹⁴-Rest), vorzugsweise (-C(=O)OR¹) mit R¹ = C₁-C₁₂-Alkyl, C₂-C₁₂-Alkenyl, C₅-C₁₂ Aryl, C₁-C₁₂ Acryl, insbesondere C₃-C₁₂ Acryloxy, C₃-C₁₂ Acrylamino, C₄-C₁₂-Methacryl, insbesondere C₄-C₁₂-Methacryloxy, C₄-C₁₂-Methacrylamino, C₄-C₁₂-Maleat, C₄-C₁₂-Maleatanhydrid, C₄-C₁₂-Maleinimid; C₁-C₁₂-Carbonyl, insbesondere R³C(=O)- mit R³=H, C₁-Cs-Alkyl oder C₁-C₁₂-Aryl, dabei insbesondere Phenyl;
C₁-C₁₄-Oxycarbonyl- (d.h. -O(C=O)R² mit R² = C₁- bis C¹⁴-Rest), vorzugsweise (-O(C=O)R²) mit R² = C₁-C₁₂-Alkyl, C₂-C₁₂-Alkenyl, dabei insbesondere C₂-Alkenyl, C₅-C₁₂-Aryl, C₃-C₁₂-Acryl, insbesondere C₃-C₁₂-Acryloxy und C₃-C₁₂-Acrylamino, C₄-C₁₂-Methacryl, insbesondere C₄-C₁₂-Methacryloxy, C₄-C₁₂-Methacrylamino, C₄-C₁₂-Maleat, C₄-C₁₂-Maleatanhydrid, C₄-C₁₂-Maleinimid, C₁-C₁₂-Carbonyl, insbesondere R³C(=O)- mit R³=H, C₁-Cs-Alkyl, C₁-C₁₂-Aryl, dabei insbesondere Phenyl;
C₁-C₁₄-Amid- (d.h. -NH(C=O)R² mit R² = C₁- bis C¹⁴-Rest), vorzugsweise (-NH(C=O)R²) mit R² = C₁-C₁₂-Alkyl, C₂-C₁₂-Alkenyl, dabei insbesondere C₂-Alkenyl, C₅-C₁₂-Aryl, C₃-C₁₂-Acryl, insbesondere C₃-C₁₂-Acryloxy und C₃-C₁₂-Acrylamino, C₄-C₁₂-Methacryl, insbesondere C₄-C₁₂-Methacryloxy, C₄-C₁₂-Methacrylamino, C₄-C₁₂-Maleat, C₄-C₁₂-Maleatanhydrid, C₄-C₁₂-Maleinimid, C₁-C₁₂-Carbonyl, insbesondere R³C(=O)- mit R³=H, C₁-C₃-Alkyl, C₁-C₁₂-Aryl, dabei insbesondere Phenyl;
C₁-C₁₂-Alkyl, vorzugsweise Methyl, Ethyl, Propyl;
C₂-C₁₂-Alkenyl, vorzugsweise C₂-C₆-Alkenyl, insbesondere Vinyl;
C₁-C₁₂-Aldehyd, C₁-C₁₂-Peroxo, C₁-C₁₂-Mercapto, C₁-C₁₂-Thiocyanato, C₃-C₁₂-Glycidylether, C₂-C₁₂-Epoxy-, insbesondere C₃-C₁₂-Acryloxy-, C₄-C₁₂-Methacryloxy-;
X einen Linker darstellt, vorzugsweise ausgewählt aus C₁-C₅-Alkylen, insbesondere Methylen, Ethylen, Propylen, C₅-C₈-Arylen, Cs-Ce-Ether, C₃-Cs-Thioether;
Y unabhängig voneinander für C₁-C₅-Alkyl steht,
n für eine ganze Zahl von 1 bis 100, bevorzugt 1 bis 15 steht,
und/oder Gemische hiervon.
Besonders bevorzugt ist n = 1.

7. Verbundmaterial gemäß mindestens einem der vorhergehenden Ansprüche, wobei die siliciumorganische Verbindung ausgewählt ist aus
- Alkoxysilan ausgewählt aus Tetraethylorthosilikat (TEOS), (3-Aminopropyl)triethoxysilan (APTES), Vinyltriethoxysilan (VEOS), 3-Methacryloxypropyltrimethoxysilan (MEMO), (3-Glycidyloxypropyl)trimethoxysilan (GLYMO), (3-Mercaptopropyl)trimethoxysilan (MTMO), 3-Thiocyanatopropyltriethoxysilane (TCPS),
- Siloxan, ausgewählt aus Disiloxan, insbesondere Hexamethyldisiloxan (HMDSO), und Octamethyltrisiloxan,
- Silan, ausgewählt aus Disilan (Si₂H₆) und Trisilan (Si₃H₈)
- Organosilan ausgewählt aus Tetramethylsilan (TMS), und
- Gemischen hiervon.

8. Verbundmaterial gemäß mindestens einem der vorhergehenden Ansprüche, wobei die Oberfläche der Haftvermittlerschicht und/oder die Haftvermittlerschicht insgesamt enthält:
| | |
|---|---|
| Si: | 3 at% bis 25 at%, insbesondere 4 at% bis 20 at%, |
| C: | 25 at% bis 90 at%, insbesondere 30 at% bis 85 at%, |
| O: | 7 at% bis 65 at%, insbesondere 15 at% bis 50 at%, |
wobei die Summe aus Si + C + O bevorzugt > 80 at% ist,
wobei der Rest bevorzugt H, N, S und gegebenenfalls weitere Elemente aus dem Substrat sind.

9. Verbundmaterial gemäß mindestens einem der vorhergehenden Ansprüche, wobei die Polymerschicht mindestens ein Polymer aufweist, das ausgewählt ist aus Fluorkautschuk (FKM), Ethylen-Propylen-Copolymere, wie Ethylen-Propylen-Dien-Kautschuk (EPDM), Polyacrylat-Kautschuk (ACM), Ethylen-Acrylat-Kautschuk (AEM), Butadien-Kautschuk, wie Acrylnitril-butadienkautschuk (NBR), hydrierte Acrylnitril-butadienkautschuk (HNBR), Styrol-Butadien-Kautschuk (SBR), Silikon-Kautschuke, Naturkautschuk (NR), Chloropren-Kautschuk (CR), Epichlorhydrin-Kautschuk (ECO), Polyurethan und/oder Epoxid-Polymer.

10. Verbundmaterial gemäß mindestens einem der vorhergehenden Ansprüche, wobei die Polymerschicht aus dem Kautschuk FKM erhältlich ist und die Polymerschicht einen Füllstoffanteil von mindestens 30 pHr, bevorzugt mindestens 50 pHr aufweist, und/oder wobei die Polymerschicht aus den Kautschuken Ethylen-Propylen-Copolymere, wie Ethylen-Propylen-DienKautschuk (EPDM), Polyacrylat-Kautschuk (ACM), Ethylen-Acrylat-Kautschuk (AEM), Butadien-Kautschuk, wie Acrylnitril-butadienkautschuk (NBR), hydrierte Acrylnitril-butadienkautschuk (HNBR), Styrol-Butadien-Kautschuk (SBR), Silikon-Kautschuke, Naturkautschuk (NR), Chloropren-Kautschuk (CR), Epichlorhydrin-Kautschuk (ECO), Polyurethan und/oder Epoxid-Polymere erhältlich ist und die Polymerschicht einen Füllstoffanteil von mindestens 50 pHr, bevorzugt mindestens 60 pHr aufweist.

11. Verbundmaterial gemäß mindestens einem der vorhergehenden Ansprüche, wobei die Verbindung zwischen Polymerschicht und Substratschicht keine formschlüssige Verbindung ist.

12. Dichtungsartikel, insbesondere ausgewählt aus einer Flanschdichtung, einer Steckverbindung, einem Metall-O-Ring, einer Ventil-, Flüssigdichtung, einer integrierten statische Dichtung auf metallischem oder polymerem Bauteil, einer Gleitringdichtung, einem Radialwellendichtring, einer Labyrinthwellendichtung, einer Flachdichtung, einem Kolbenring, einem Magnetanker, einem Faltenbalg und einer Membrandichtung, enthaltend ein Verbundmaterial gemäß mindestens einem der vorhergehenden Ansprüche.

13. Verfahren zur Herstellung eines Verbundmaterials oder eines Dichtungsartikels gemäß mindestens einem der vorhergehenden Ansprüche, umfassend die Schritte:
(e) Bereitstellen der Substratschicht,
(f) Beschichten der Substratschicht mit der Haftvermittlerschicht durch plasmagestützte chemische Gasphasenabscheidung (PE-CVD),
(g) Auftragen einer Polymerverbindung, die beim Vernetzen eine Polymerschicht mit einer Shore-Härte von 60 bis 95 Shore ergeben kann, auf die Haftvermittlerschicht, so dass die Substratschicht zumindest teilweise mit der Polymerverbindung versehen ist,
(h) Vernetzen der Polymerverbindung, so dass eine Polymerschicht mit einer Shore-Härte von 60 bis 95 Shore A erhalten wird und wobei die Haftvermittlerschicht mit der Polymerschicht vorzugsweise kovalent verbunden wird.

14. Verfahren nach Anspruch 13, wobei das Auftragen der Polymerverbindung so erfolgt, dass die Substratschicht Bereiche aufweist, die mit der Polymerverbindung versehen sind, und andere Bereiche, die nicht mit der Polymerverbindung versehen sind.

15. Verwendung eines Verbundmaterials gemäß mindestens einem der Ansprüche 1 bis 11 als Dichtungsartikel, insbesondere ausgewählt aus einer Flanschdichtung, einer Steckverbindung, einem Metall-O-Ring, einer Ventil-, Flüssigdichtung, einer integrierten statische Dichtung auf metallischem oder polymerem Bauteil, einer Gleitringdichtung, einem Radialwellendichtring, einer Labyrinthwellendichtung, einer Flachdichtung, einem Kolbenring, einem Magnetanker, einem Faltenbalg und einer Membrandichtung, oder zur Herstellung eines Dichtungsartikels.
